# EUROPEAN PATENT APPLICATION

(11) **EP 4 254 471 A1**
(43) Date of publication of application: **04.10.2023**
(21) Application number: 23162295.2
(22) Date of filing: 16.03.2023
(51) Int. Cl.: H01L 21/67, H01L 21/68, H01L 21/78, H01L 21/66

(54) **PROCESSING METHOD FOR WORKPIECE**

(30) Priority: 23.03.2022 JP 2022046557
(71) Applicant: Disco Corporation, Tokyo 143-8580 (JP)
(72) Inventor: KOJIMA, Yoshimasa, Tokyo 143-8580 (JP); KUBO, Atsushi, Tokyo 143-8580 (JP); HANAJIMA, Satoshi, Tokyo 143-8580 (JP)
(74) Representative: Hoffmann Eitle

(57) **Abstract**

A processing method for a workpiece includes forming a first processing groove by a first processing unit, imaging the first processing groove by a first imaging unit and imaging, by a second imaging unit provided on an opposite side of the first imaging unit with respect to the holding table, a predetermined line that is formed in a position corresponding to that of the first processing groove in a thickness direction of the workpiece, detecting whether or not a position of a first center line of the first processing groove and a position of a second center line of the predetermined line are aligned in a predetermined plane, and correcting the processing position in such a manner as to make the positions of the two center lines aligned when the detected positions of the first center line and the second center line are not being aligned.

## Description

### BACKGROUND OF THE INVENTION

### Field of the Invention

The present invention relates to a processing method for a workpiece that processes a workpiece held on a holding table that has an area formed with a transparent material.

### Description of the Related Art

Electronic apparatuses as exemplified by mobile phones and personal computers have device chips mounted thereon. The device chips are normally manufactured by dividing a workpiece such as a silicon wafer which has a plurality of devices exemplified by integrated circuits (ICs) formed on a face side thereof. In order to divide the workpiece, for example, a cutting apparatus is used. The cutting apparatus includes a chuck table that has a holding surface for holding the workpiece under suction. Above the chuck table, there is provided a cutting unit that includes a spindle to which a cutting blade is mounted.

When the workpiece is to be divided, normally, first, a reverse side of the workpiece is held under suction on the holding surface of the chuck table, while the face side of the workpiece is exposed upward. Next, the cutting blade sequentially cuts into the workpiece to cut the workpiece along a plurality of projected dicing lines set in a grid pattern on the face side of the workpiece, so that the workpiece is divided into individual device chips. When the workpiece is to be divided, in order to prevent cracks or chipping from occurring at the time of the cutting processing, there is known a processing method of cutting, after cut grooves are formed on each of the face side and the reverse side, the workpiece in such a manner that the cut grooves are connected to each other in a thickness direction of the workpiece (see, for example, Japanese Patent Laid-open No. Hei 6-275583).

In the processing method described in Japanese Patent Laid-open No. Hei 6-275583, grooves having a V-shape as viewed in cross section (V-shaped grooves) are formed in each of the face side and the reverse side of the workpiece in such a manner as to be positioned in corresponding positions in the thickness direction of the workpiece, and thereafter, the workpiece is cut in such a manner that the V-shaped grooves in the face side and the V-shaped grooves in the reverse side are connected to each other. To this end, in the processing method described in Japanese Patent Laid-open No. Hei 6-275583, first, the face side of the workpiece on which a plurality of projected dicing lines are set is held under suction on the chuck table, and the reverse side of the workpiece is exposed upward. Next, alignment marks (target marks) formed on the face side of the workpiece are imaged through alignment windows and observation windows that are formed in a plurality of locations in the chuck table.

After alignment is performed, V-shaped grooves are formed along the projected dicing lines in the reverse side of the workpiece. Then, the workpiece is turned upside down, and V-shaped grooves are formed also in the face side. Thereafter, a cutting blade that has a blade thickness smaller than a width of the V-shaped groove cuts the workpiece in such a manner that the V-shaped grooves formed in corresponding positions in the thickness direction of the workpiece are connected to each other. However, in the case of cutting the reverse side of the workpiece by the cutting apparatus mentioned above, for example, if there is any distortion in the shape of the alignment marks formed on the face side, the position of the center line of the V-shaped groove formed in the face side (that is, a center line that passes through the center position of the width of the V-shaped groove in the width direction of the V-shaped groove orthogonal to the longitudinal direction of the V-shaped groove and that is parallel to the longitudinal direction) and the position of the center line of the V-shaped groove formed in the reverse side are sometimes misaligned in a predetermined plane due to misalignment of the cutting blade.

Incidentally, in the case where the workpiece is to be cut from the face side of the workpiece to the reverse side thereof, there are cases where what is generally called oblique cutting occurs due to the cutting blade cutting into the workpiece obliquely with respect to the thickness direction of the workpiece (see, for example, Japanese Patent Laid-open No. 2020-113635). When oblique cutting occurs, normally, the position of the center line of a cut groove exposed on the reverse side and the position of the center line of a cut groove exposed on the face side are misaligned in a predetermined plane, e.g., an X-Y plane. Hence, when the position of the center line of the cut groove exposed on the face side and the position of the center line of the projected dicing line formed on the face side are aligned in a predetermined plane, the position of the center line of the cut groove exposed on reverse side and the position of the center line of the projected dicing line formed on the face side are in turn misaligned in a predetermined plane.

However, even in a case where oblique cutting occurs, there are cases where the position of the center line of the cut groove exposed on the reverse side and the position of the center line of the projected dicing line formed on the face side need to be aligned in a predetermined plane in order to meet the specification requirements for the shape of the device chips.

### SUMMARY OF THE INVENTION

The present invention has been made in view of the abovementioned problems and has, as an object thereof, to allow processing to proceed, in a case where the positions of the center lines that need to be aligned in both sides of the workpiece are misaligned in a predetermined plane, after the processing positions are corrected in such a manner as to align the positions of the two center lines.

In accordance with an aspect of the present invention, there is provided a processing method for a workpiece, including a first processing groove forming step of forming, by a first processing unit, a first processing groove that has a depth not reaching a face side of the workpiece, in a state in which the face side is held and a reverse side of the workpiece that is positioned on an opposite side of the face side is exposed, an imaging step of, after the first processing groove forming step, imaging the first processing groove by a first imaging unit, in a state in which the workpiece is held by a holding table having an area formed with a transparent material, and imaging, by a second imaging unit provided on an opposite side of the first imaging unit with respect to the holding table, a predetermined line that is provided on the face side and that is formed at a position corresponding to that of the first processing groove in a thickness direction of the workpiece, a detecting step of, after the imaging step, detecting whether or not a position of a first center line of the first processing groove imaged by the first imaging unit and a position of a second center line of the predetermined line imaged by the second imaging unit are aligned in a predetermined plane, and a correcting step of, when the position of the first center line and the position of the second center line are detected as not being aligned in the detecting step, correcting a processing position in such a manner as to make the positions of the two center lines aligned.

Preferably, the processing method further includes, before the imaging step, a second processing groove forming step of forming, by a second processing unit, a second processing groove that is positioned on an opposite side of the first processing groove in the thickness direction of the workpiece and that has a depth not reaching the first processing groove, in a state in which the reverse side is held on the holding table and the face side is exposed, in which the predetermined line is an opening of the second processing groove formed in the face side, in the detecting step, whether or not the position of the first center line of the first processing groove imaged by the first imaging unit and the position of the second center line of the second processing groove imaged by the second imaging unit are aligned in the predetermined plane is detected, and, in the correcting step, a processing position of the second processing unit is corrected.

Moreover, preferably, at least one of the first processing unit or the second processing unit has a cutting blade that has a V-shaped outer circumferential end portion as viewed in cross section, and at least one of the first processing groove or the second processing groove has a V-shape as viewed in cross section, according to the shape of the outer circumferential end portion of the cutting blade.

Further, preferably, at least one of the first processing unit or the second processing unit is a laser application unit that is capable of emitting a pulsed laser beam having a wavelength absorbable by the workpiece.

Further, preferably, the processing method further includes a dividing step of dividing the workpiece by a third processing unit in such a manner as to connect to each other the first processing groove and the second processing groove that are formed in corresponding positions in the thickness direction of the workpiece.

Further, preferably, the predetermined line is a projected dicing line set on the face side, in the imaging step, the projected dicing line is imaged by the second imaging unit, and, in the correcting step, a processing position of the first processing unit is corrected.

In accordance with another aspect of the present invention, there is provided a processing method for a workpiece, including a first processing groove forming step of forming, by a first processing unit, a first processing groove that has a depth reaching a face side of the workpiece, in a state in which the face side is held and a reverse side of the workpiece that is positioned on an opposite side of the face side is exposed, an imaging step of, after the first processing groove forming step, imaging the first processing groove exposed on the reverse side, by an upper side imaging unit that is located above a holding table having an area formed with a transparent material, in a state in which the face side of the workpiece is held under suction on the holding table, and imaging an alignment mark formed on the face side, by a lower side imaging unit that is located below the holding table, a detecting step of, after the imaging step, detecting whether or not a position of a first center line of the first processing groove imaged by the upper side imaging unit and a position of a second center line of a projected dicing line identified in reference to the alignment mark imaged by the lower side imaging unit are aligned in a predetermined plane, and a correcting step of, when the position of the first center line and the position of the second center line are detected as not being aligned in the detecting step, correcting a processing position in such a manner as to align the positions of the two center lines.

In accordance with a further aspect of the present invention, there is provided a processing method for a workpiece, including a first processing groove forming step of forming, by a first processing unit, a first processing groove that has a depth reaching a reverse side of the workpiece, in a state in which the reverse side of the workpiece is held and a face side of the workpiece that is positioned on an opposite side of the reverse side is exposed, an imaging step of, after the first processing groove forming step, imaging the first processing groove exposed on the reverse side, by a lower side imaging unit that is located below a holding table having an area formed with a transparent material, in a state in which the reverse side of the workpiece is held under suction on the holding table, and imaging an alignment mark formed on the face side, by an upper side imaging unit that is located above the holding table, a detecting step of, after the imaging step, detecting whether or not a position of a first center line of the first processing groove imaged by the lower side imaging unit and a position of a second center line of a projected dicing line identified in reference to the alignment mark imaged by the upper side imaging unit are aligned in a predetermined plane, and a correcting step of, when the position of the first center line and the position of the second center line are detected as not being aligned in the detecting step, correcting a processing position in such a manner as to align the positions of the two center lines.

In the processing method according to one aspect of the present invention, the first processing groove formed on the reverse side of the workpiece is imaged by the first imaging unit, and the predetermined line that is provided on the face side of the workpiece and that is formed in a position corresponding to that of the first processing groove in the thickness direction of the workpiece is imaged by the second imaging unit (imaging step). After the imaging step, whether or not the position of the first center line of the first processing groove imaged by the first imaging unit and the position of the second center line of the predetermined line imaged by the second imaging unit are aligned in the predetermined plane is detected (detecting step). Further, in a case where the position of the first center line and the position of the second center line are not aligned, the processing position is corrected in such a manner as to align the positions of the two center lines (correcting step). In this manner, directly observing the face side and the reverse side of the workpiece allows the misalignment between the position of the first center line and the position of the second center line to be detected. Accordingly, even in a case where a positional misalignment occurs between the two center lines, the workpiece can be processed after correction is made in such a manner as to align the positions of the two center lines. Thus, the processing accuracy for the workpiece can be improved.

In the processing method according to the other aspect of the present invention, in a case where the position of the first center line of the first processing groove imaged by the upper side imaging unit and the position of the second center line of the projected dicing line identified in reference to the alignment mark imaged by the lower side imaging unit are not aligned in the predetermined plane, the processing position is corrected in such a manner as to align the positions of the two center lines. In the processing method according to the further aspect of the present invention, in a case where the position of the first center line of the first processing groove imaged by the lower side imaging unit and the position of the second center line of the projected dicing line identified in reference to the alignment mark imaged by the upper side imaging unit are not aligned in the predetermined plane, the processing position is corrected in such a manner as to align the positions of the two center lines. Hence, even in a case where oblique cutting occurs, the position of the first center line and the position of the second center line can be aligned. In this manner, the center lines that need to be aligned in both sides of the workpiece can be aligned.

The above and other objects, features and advantages of the present invention and the manner of realizing them will become more apparent, and the invention itself will best be understood from a study of the following description and appended claims with reference to the attached drawings showing some preferred embodiments of the invention.

### BRIEF DESCRIPTION OF THE DRAWINGS

FIG. 1 is a perspective view of a cutting apparatus according to a first embodiment of the present invention;
FIG. 2 is a perspective of a workpiece unit;
FIG. 3 is a perspective view of a chuck table;
FIG. 4 is a partially cross sectional side view of the chuck table;
FIG. 5 is an enlarged view of a region A illustrated in FIG. 4;
FIG. 6 is an enlarged perspective view of a lower side imaging unit;
FIG. 7 is a flowchart of a processing method that is a cutting method according to the first embodiment;
FIG. 8 is a view illustrating a first processing groove forming step according to the first embodiment;
FIG. 9 is a cross sectional view of a workpiece that has undergone an inverting step according to the first embodiment;
FIG. 10 is a view illustrating a second processing groove forming step according to the first embodiment;
FIG. 11 is a view illustrating an imaging step according to the first embodiment;
FIG. 12A is a view illustrating an example of an image acquired by an upper side imaging unit;
FIG. 12B is a view illustrating an example of an image acquired by the lower side imaging unit;
FIG. 13A is an enlarged cross sectional view illustrating part of the workpiece in a case where positions of center lines of processing grooves are aligned;
FIG. 13B is an enlarged cross sectional view of part of the workpiece in a case where the positions of the center lines of the processing grooves are misaligned;
FIG. 14 is a view illustrating an additional second processing groove forming step according to the first embodiment;
FIG. 15 is a view illustrating a dividing step according to the first embodiment;
FIG. 16 is a view illustrating the first processing groove forming step according to a second embodiment of the present invention;
FIG. 17 is a view illustrating the second processing groove forming step according to the second embodiment;
FIG. 18 is a view illustrating the imaging step according to the second embodiment;
FIG. 19 is a view illustrating the additional second processing groove forming step according to the second embodiment;
FIG. 20 is a view illustrating the dividing step according to the second embodiment;
FIG. 21 is a perspective view of a laser processing apparatus according to a third embodiment of the present invention;
FIG. 22 is a view illustrating the first processing groove forming step according to the third embodiment;
FIG. 23 is a view illustrating the second processing groove forming step according to the third embodiment;
FIG. 24 is a view illustrating the imaging step according to the third embodiment;
FIG. 25 is a view illustrating the additional second processing groove forming step according to the third embodiment;
FIG. 26 is a view illustrating the dividing step according to the third embodiment;
FIG. 27A is a partially cross sectional side view illustrating an expanding apparatus and other components according to a fourth embodiment of the present invention;
FIG. 27B is a view illustrating the dividing step according to the fourth embodiment;
FIG. 28 is a flowchart of the processing method according to a fifth embodiment of the present invention;
FIG. 29 is a view illustrating the first processing groove forming step according to the fifth embodiment;
FIG. 30 is a view illustrating the imaging step according to the fifth embodiment;
FIG. 31A is an enlarged cross sectional view illustrating part of the workpiece in a case where the positions of the center lines are aligned in the fifth embodiment;
FIG. 31B is an enlarged cross sectional view illustrating part of the workpiece in a case where the positions of the center lines are not aligned in the fifth embodiment;
FIG. 32 is a view illustrating the first processing groove forming step according to a sixth embodiment of the present invention;
FIG. 33 is a view illustrating the imaging step according to the sixth embodiment; and
FIG. 34 is a view illustrating the imaging step according to a seventh embodiment of the present invention.

### DETAILED DESCRIPTION OF THE PREFERRED EMBODIMENTS

### (First embodiment)

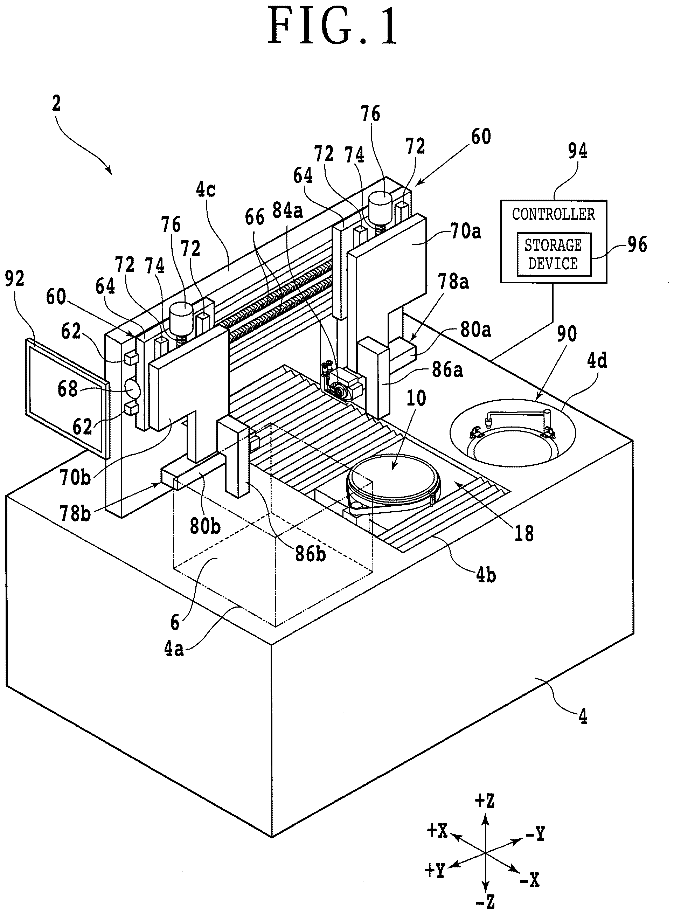

Embodiments according to the aspects of the present invention will be described with reference to the attached drawings. FIG. 1 is a perspective view of a cutting apparatus 2 according to a first embodiment of the present invention. Note that, in FIG. 1, some components are illustrated in functional blocks. In FIG. 1, an X-axis direction (a processing feed direction), a Y-axis direction (an indexing feed direction), and a Z-axis direction (a vertical direction) are orthogonal to each other. The X-axis direction is parallel to a +X direction and a -X direction. Similarly, the Y-axis direction is parallel to a +Y direction and a -Y direction, and the Z-axis direction is parallel to a +Z direction and a -Z direction.

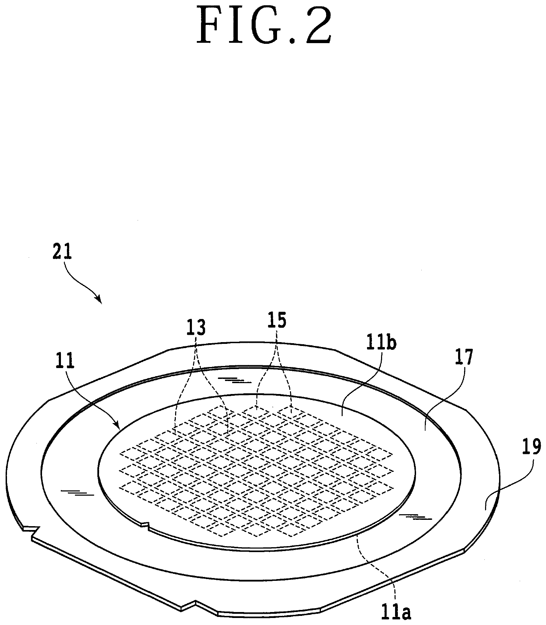

The cutting apparatus 2 includes a base 4 that supports the components of the cutting apparatus 2. On a corner portion on the front side (in the +Y direction) of the base 4, an opening 4a is formed. Inside the opening 4a, a cassette elevator (not illustrated) is provided. On an upper surface of the cassette elevator, a cassette 6 for accommodating a plurality of workpieces 11 (see FIG. 2) is placed. The workpiece 11 includes, for example, a circular plate-shaped single-crystal substrate (wafer) that is formed with such semiconductor materials as silicon (Si) or silicon carbide (SiC). Yet, there are no limitations on the shape, structure, size, and the like of the workpiece 11. The workpiece 11 may include a substrate formed with such materials as other semiconductors, ceramic, resin, or metal.

As illustrated in FIG. 2, a plurality of projected dicing lines 13 are set in a grid pattern on a face side 11a of the workpiece 11. Each area demarcated by the plurality of projected dicing lines 13 is formed with a device 15 such as an IC, an alignment mark (not illustrated), and the like. To the face side 11a, a tape (dicing tape) 17 having a larger diameter than the workpiece 11 is affixed.

The tape 17 has a laminated structure including a base layer and an adhesive layer (glue layer) and is formed with a transparent material through which light in a predetermined wavelength band such as visible light and infrared light can transmit. The base layer is, for example, formed with polyolefin (PO) or the like. The adhesive layer is, for example, formed with adhesive resin such as ultraviolet (UV) curable acrylic resin. To a central part of the adhesive layer of the tape 17, the face side 11a of the workpiece 11 is affixed.

To an outer circumferential portion of the tape 17, one surface of an annular frame 19 that is made of metal is affixed, so that a workpiece unit 21 in which the workpiece 11 is supported by the frame 19 via the tape 17 is formed. FIG. 2 is a perspective view of the workpiece unit 21. The workpiece unit 21 is accommodated in the cassette 6 in a state in which a reverse side 11b of the workpiece 11 that is positioned on the opposite side of the face side 11a is exposed.

As illustrated in FIG. 1, on a rear side (in the -Y direction) of the opening 4a, a rectangular opening 4b is formed. In the opening 4b, a circular plate-shaped chuck table (holding table) 10 is disposed. On an outer circumferential portion of the chuck table 10, there is provided an annular frame suction plate (not illustrated) that has a plurality of suctions ports formed along a circumferential direction.

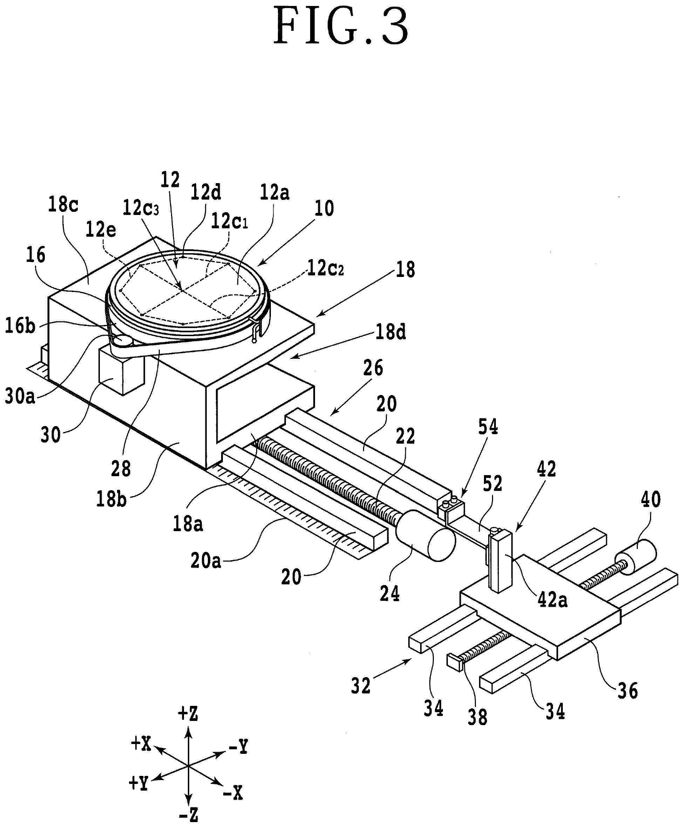

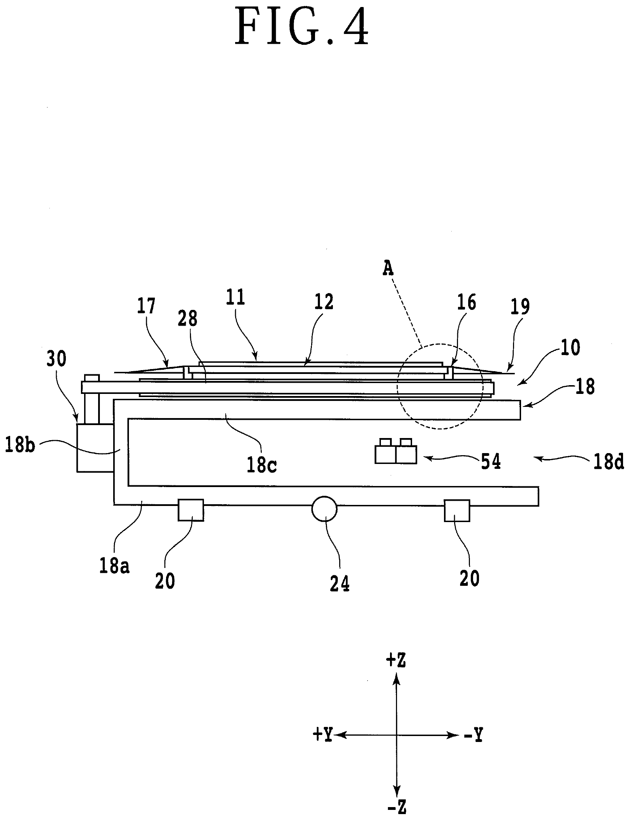

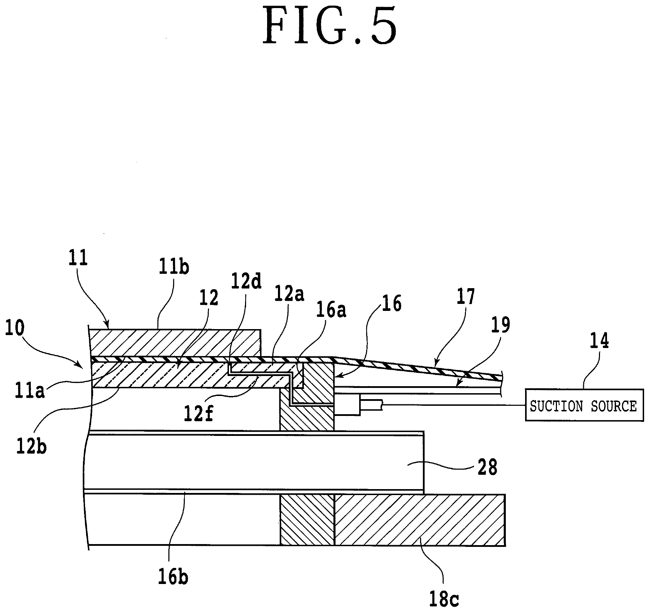

Here, the chuck table 10 and other relevant components will be described in more detail with reference to FIGS. 3 to 6. FIG. 3 is a perspective view of the chuck table 10, and FIG. 4 is a partially cross sectional side view of the chuck table 10. Note that, in FIG. 4, hatching is omitted for the sake of convenience. FIG. 5 is an enlarged view of a region A illustrated in FIG. 4. FIG. 5 illustrates one component in a functional block. The chuck table 10 includes a circular plate-shaped holding member 12. The holding member 12 includes a substantially flat first surface 12a and a substantially flat second surface 12b that is positioned on the opposite side of the first surface 12a.

The holding member 12 is formed with a transparent material through which visible light or infrared light (for example, near-infrared light) can transmit. The holding member 12 is, for example, formed with quartz glass, borosilicate glass, or soda glass, but may alternatively be formed with calcium fluoride, lithium fluoride, or magnesium fluoride. Inside the holding member 12, a linear first suction channel 12c₁ is formed in such a manner as to cross a central axis of the circular plate when the holding member 12 is viewed in top plan. Further, a linear second suction channel 12c₂ is formed in such a manner as to intersect at right angles to the first suction channel 12c₁ on a plane substantially parallel to the first surface 12a.

The first suction channel 12c₁ and the second suction channel 12c₂ are connected to each other at a center point 12c₃ that is located in the central axis of the circular plate. On an outer circumferential portion of the first surface 12a, there are formed a plurality of opening portions 12d. Each opening portion 12d is formed to have a predetermined depth not reaching the second surface 12b from the first surface 12a. The opening portions 12d are each formed in both end portions of the first suction channel 12c₁ and both end portions of the second suction channel 12c₂. The opening portions 12d are connected to each other by an outer circumferential suction channel 12e that is formed at a predetermined depth in the outer circumferential portion of the holding member 12.

On an outer circumferential side of the opening portions 12d, there is formed a suction channel 12f that extends along a radial direction, and to the suction channel 12f, a suction source 14 such as an ejector is connected (see FIG. 5). When the suction source 14 is operated to generate a negative pressure, a negative pressure is generated in the opening portions 12d. Thus, the first surface 12a functions as a holding surface for holding the workpiece unit 21 (workpiece 11) under suction. In the flow channels, such as the first suction channel 12c₁, the second suction channel 12c₂, the opening portions 12d, the outer circumferential suction channel 12e, and the suction channel 12f, part of incident light is scattered or reflected.

Hence, when viewed from the first surface 12a or the second surface 12b, the flow channels of the holding member 12 are not completely transparent, and may have translucency or may be opaque in some cases. However, predetermined areas of the holding member 12 except those channels are transparent from the first surface 12a to the second surface 12b. For example, an area that is divided into four by the first suction channel 12c₁ and the second suction channel 12c₂ and that is positioned on the inner side relative to the outer circumferential suction channel 12e in the radial direction of the holding member 12 is transparent from the first surface 12a to the second surface 12b.

On an outer circumference of the holding member 12, there is provided a cylindrical frame body 16 that is formed with a metal material such as stainless steel. An opening portion 16a is formed in an upper part of the frame body 16 (see FIG. 5), and the holding member 12 is disposed in such a manner as to cover the opening portion 16a. As illustrated in FIGS. 3 and 4, the frame body 16 is supported by an X-axis direction moving table 18. The X-axis direction moving table 18 includes a rectangular bottom plate 18a. To an end portion on the front side (in the +Y direction) of the bottom plate 18a, a lower end portion of a rectangular side plate 18b is connected.

To an upper end portion of the side plate 18b, an end portion on the front side (in the +Y direction) of a top plate 18c that has the same rectangular shape as the bottom plate 18a is connected. The bottom plate 18a and the top plate 18c are disposed in such a manner as to overlap with each other in the Z-axis direction, and the bottom plate 18a, the side plate 18b, and the top plate 18c form a space 18d in which the rear side (-Y direction side) and both sides in the X-axis direction are open. A lower side (-Z direction side) of the bottom plate 18a is attached, in a slidable manner, to a pair of X-axis guide rails 20 that are fixed to an upper surface of a stationary base (not illustrated). In the vicinity of the X-axis guide rails 20, there is provided an X-axis linear scale 20a.

On a lower surface side of the X-axis direction moving table 18, a read head (not illustrated) is provided. When the scale of the X-axis linear scale 20a is detected by the read head, the position (coordinate) and the amount of movement of the X-axis direction moving table 18 in the X-axis direction are calculated. On the lower surface side of the bottom plate 18a, there is provided a nut portion (not illustrated). To this nut portion, a screw shaft 22 that is disposed substantially parallel to the X-axis direction is coupled in a rotatable manner through balls (not illustrated). One end portion of the screw shaft 22 is coupled to a motor 24.

When the motor 24 is operated, the screw shaft 22 rotates, and the X-axis direction moving table 18 moves along the X-axis direction. The X-axis direction moving table 18, the pair of X-axis guide rails 20, the screw shaft 22, the motor 24, and the like configure an X-axis direction moving mechanism 26. On an upper surface side of the top plate 18c, the abovementioned frame body 16 is supported in such a manner as to be rotatable about a rotational axis that is substantially parallel to the Z-axis direction. A side surface of the frame body 16 that is located higher than the top plate 18c functions as a pulley portion 16b.

On an outer side surface of the side plate 18b, a rotary drive source 30 such as a motor is provided. On a rotational shaft of the rotary drive source 30, a pulley 30a is provided. Around the pulley 30a and the pulley portion 16b, a belt 28 is wounded. When the rotary drive source 30 is operated, the frame body 16 rotates about the rotational axis that is substantially parallel to the Z-axis direction. Controlling the rotation of the pulley 30a allows the chuck table 10 to rotate by any angle about the rotational axis.

On an extension of the X-axis direction moving mechanism 26 in the X-axis direction, there is provided a Y-axis direction moving mechanism 32 that moves a lower side imaging unit (first imaging unit) 54 in the Y-axis direction. The Y-axis direction moving mechanism 32 includes a pair of Y-axis guide rails 34 that are substantially parallel to the Y-axis direction. The pair of Y-axis guide rails 34 are fixed to an upper surface of a stationary base (not illustrated). On the Y-axis guide rails 34, a Y-axis direction moving table 36 is attached in a slidable manner. On a lower surface side of the Y-axis direction moving table 36, a nut portion (not illustrated) is provided. To this nut portion, a screw shaft 38 that is disposed substantially parallel to the Y-axis direction is coupled in a rotatable manner through balls (not illustrated).

To one end portion of the screw shaft 38, a motor 40 is coupled. When the screw shaft 38 is rotated by the motor 40, the Y-axis direction moving table 36 moves along the Y-axis direction. In the vicinity of the Y-axis guide rails 34, a Y-axis linear scale (not illustrated) is provided. On the lower surface side of the Y-axis direction moving table 36, a read head (not illustrated) is provided. When the scale of the Y-axis linear scale is detected by the read head, the position (coordinate) and the amount of movement of the Y-axis direction moving table 36 in the Y-axis direction are calculated.

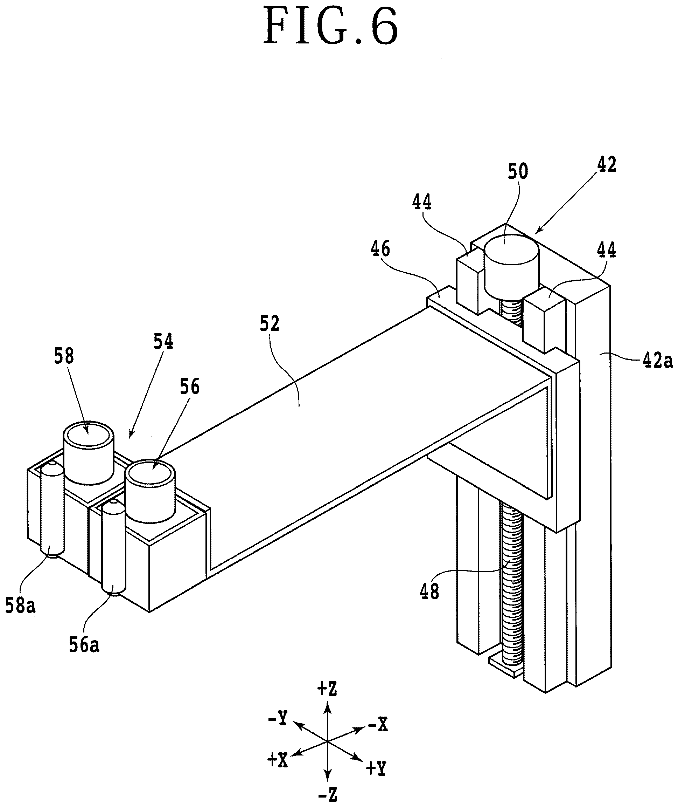

On an upper surface of the Y-axis direction moving table 36, a Z-axis direction moving mechanism 42 is provided. The Z-axis direction moving mechanism 42 has a support structure 42a that is fixed to the upper surface of the Y-axis direction moving table 36. As illustrated in FIG. 6, to one surface of the support structure 42a, a pair of Z-axis guide rails 44 that are disposed substantially parallel to the Z-axis direction are fixed. To the Z-axis guide rails 44, a Z-axis moving plate 46 is attached in a slidable manner. On the support structure 42a side of the Z-axis moving plate 46, a nut portion (not illustrated) is provided. To this nut portion, a screw shaft 48 that is disposed substantially parallel to the Z-axis direction is coupled in a rotatable manner through balls (not illustrated).

To an upper end portion of the screw shaft 48, a motor 50 is coupled. When the screw shaft 48 is rotated by the motor 50, the Z-axis moving plate 46 moves along the Z-axis direction. In the vicinity of the Z-axis guide rails 44, a Z-axis linear scale (not illustrated) is provided. The Z-axis moving plate 46 is provided with a read head (not illustrated). When the scale of the Z-axis linear scale is detected by the read head, the position (coordinate) and the like of the Z-axis moving plate 46 in the Z-axis direction are calculated.

To the Z-axis moving plate 46, the lower side imaging unit 54 is fixed through a support arm 52 that has a longitudinal portion disposed along the X-axis direction. FIG. 6 is an enlarged perspective view of the lower side imaging unit 54. The lower side imaging unit 54 is what is generally called a photomicrographic camera unit that includes a low magnification camera 56 and a high magnification camera 58. Each of the low magnification camera 56 and the high magnification camera 58 includes a predetermined optical system such as a condenser lens and an imaging element such as a charge-coupled device (CCD) image sensor or a complementary metal-oxide-semiconductor (CMOS) image sensor (both of which are not illustrated). In the present embodiment, an imaging element that can photoelectrically convert visible light is used.

The lower side imaging unit 54 is disposed on a lower side with respect to the chuck table 10 (that is, on an opposite side of the upper side imaging units 86a and 86b with respect to the chuck table 10). Further, the optical axis of each condenser lens is disposed substantially orthogonal to the second surface 12b of the holding member 12. On a lateral side of the low magnification camera 56, there is provided a lighting unit 56a that emits visible light to the workpiece 11 and other components that are disposed on the upper side of the low magnification camera 56. Similarly, on a lateral side of the high magnification camera 58, a lighting unit 58a is provided. In a case where the workpiece 11 is to be imaged by the lower side imaging unit 54, the X-axis direction moving table 18 is moved to dispose the lower side imaging unit 54 in the space 18d. Further, when the workpiece 11 is to be imaged from the lower side via the holding member 12, an image of the face side 11a can be obtained.

Here, described with reference to FIG. 1 again are the other components of the cutting apparatus 2. On both sides of the top plate 18c in the X-axis direction, bellows-shaped covers that are expandable and contractible are attached in such a manner as to cover the opening 4b. Further, on the upper side of the opening 4b, a portal-shaped support structure 4c is provided in such a manner as to straddle the opening 4b in the Y-axis direction. On one side surface of the support structure 4c in the -X direction, two processing unit moving mechanisms (indexing feed units, cutting feed units) 60 are provided. The processing unit moving mechanisms 60 include a pair of Y-axis guide rails 62 that are fixed to the one side surface of the support structure 4c.

The pair of Y-axis guide rails 62 are disposed substantially parallel to the Y-axis direction. To the pair of Y-axis guide rails 62, two Y-axis moving plates 64 are attached in such a manner as to be slidable independently of each other. On one surface of each of the Y-axis moving plates 64, a nut portion (not illustrated) is provided. To this nut portion, a screw shaft 66 disposed substantially parallel to the Y-axis direction is coupled in a rotatable manner through balls (not illustrated). The nut portion of each of the Y-axis moving plates 64 is coupled to different screw shafts 66. To one end portion of each of the screw shafts 66, a motor 68 is coupled. When the screw shaft 66 is rotated by the motor 68, the Y-axis moving plate 64 moves along the Y-axis direction. To the pair of Z-axis guide rails 72 provided on the other surface of the Y-axis moving plate 64 that is located on the rear side (in the -Y direction), one surface of a Z-axis moving plate 70a is attached in a slidable manner. Similarly, to the pair of Z-axis guide rails 72 disposed on the other surface of the Y-axis moving plate 64 that is located on the front side (in the +Y direction), one surface of a Z-axis moving plate 70b is attached in a slidable manner.

On one surface of each of the Z-axis moving plate 70a and the Z-axis moving plate 70b, a nut portion (not illustrated) is provided. To the nut portion, a screw shaft 74 is coupled in a rotatable manner through balls (not illustrated). Each screw shaft 74 is disposed substantially parallel to the Z-axis direction. To an upper end portion of each of the screw shafts 74, a motor 76 is coupled. When the screw shafts 74 are rotated by the motors 76, the Z-axis moving plate 70a and the Z-axis moving plate 70b each move along the Z-axis direction.

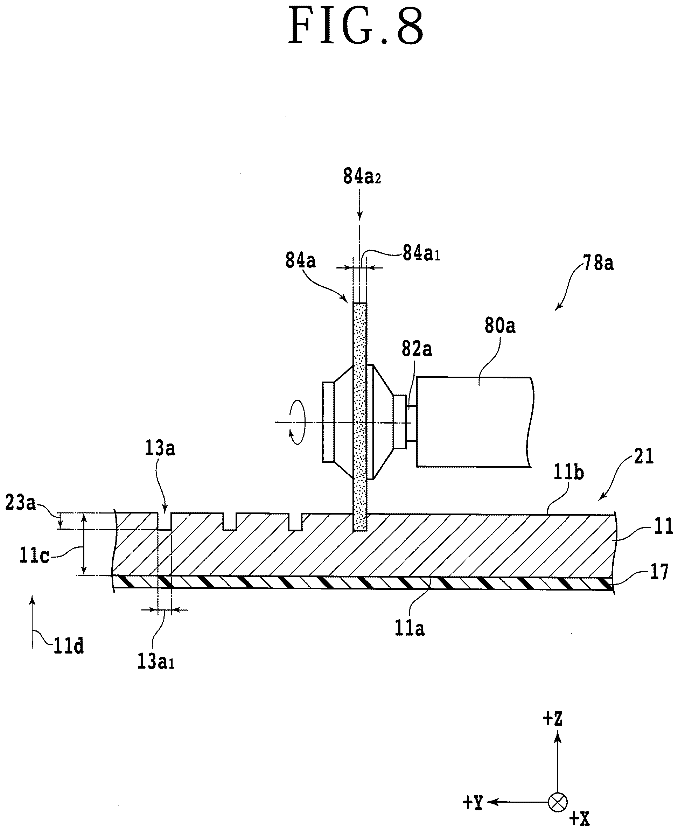

On a lower part of the Z-axis moving plate 70a disposed on the rear side (in the -Y direction), a first cutting unit (first processing unit, second processing unit) 78a is provided. The first cutting unit 78a includes a tubular spindle housing 80a. Inside the spindle housing 80a, part of a cylindrical spindle 82a (see FIG. 8) is housed in a rotatable manner. To one end portion of the spindle 82a, a rotary drive source (not illustrated) such as a motor is provided. To the other end portion of the spindle 82a, a first cutting blade 84a that has an annular cutting edge is mounted. The first cutting blade 84a according to the present embodiment is of a washer type (hubless type) but may instead be of a hub type.

To the lower part of the Z-axis moving plate 70a, the upper side imaging unit (second imaging unit) 86a is fixed. That is, the position of the upper side imaging unit 86a is fixed with respect to the first cutting unit 78a. The upper side imaging unit 86a is disposed on the upper side with respect to the chuck table 10. The upper side imaging unit 86a is what is generally called a photomicrographic camera unit. The upper side imaging unit 86a includes a predetermined optical system including, for example, a condenser lens whose optical axis lies substantially perpendicular to the first surface 12a of the holding member 12 and an imaging element that can photoelectrically convert visible light (both of which are not illustrated).

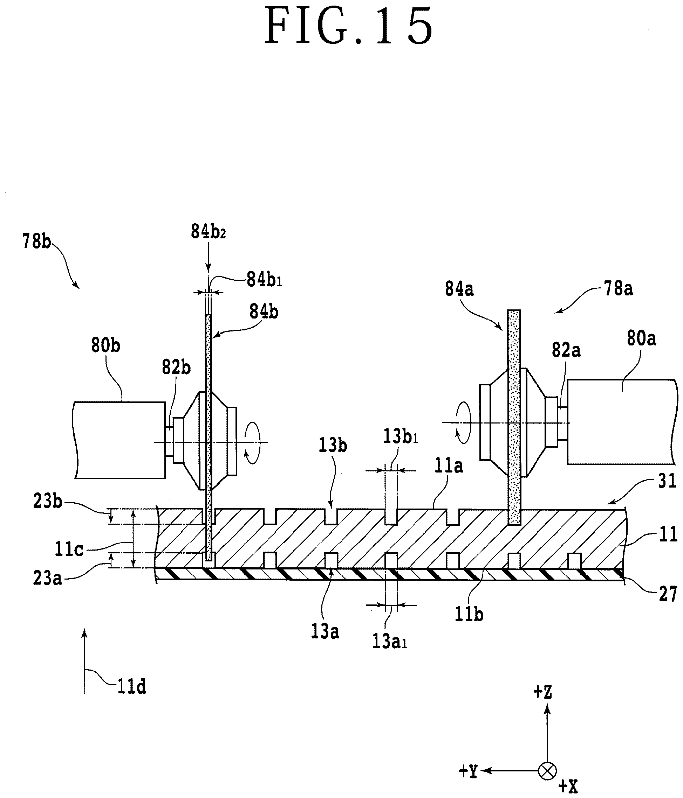

Similarly, on a lower part of the Z-axis moving plate 70b that is disposed on the front side (in the +Y direction), a third cutting unit (third processing unit) 78b is provided. The third cutting unit 78b also includes a spindle housing 80b, and inside the spindle housing 80b, part of a cylindrical spindle 82b (see FIG. 15) is housed in a rotatable manner. To one end portion of the spindle 82b, a rotary drive source (not illustrated) such as a motor is provided, while, to the other end portion of the spindle 82b, a third cutting blade 84b is mounted (see FIG. 15).

The third cutting blade 84b according to the present embodiment is of a washer type (hubless type) but may instead be of a hub type. Yet, a blade thickness 84b₁ of the third cutting blade 84b (see FIG. 15) is thin compared to a blade thickness 84a₁ of the first cutting blade 84a (see FIG. 8). Accordingly, the width of the processing groove (cut groove) that is formed when the workpiece 11 is cut by the third cutting blade 84b is smaller than a width 13a₁ of a first processing groove (cut groove) 13a formed by the first cutting blade 84a (see FIG. 15). On the lower part of the Z-axis moving plate 70b, there is provided the upper side imaging unit 86b whose position is fixed with respect to the third cutting unit 78b. The structure and other matters of the upper side imaging unit 86b are substantially identical with those of the upper side imaging unit 86a.

As illustrated in FIG. 1, on the rear side (in the -Y direction) of the opening 4b, a circular opening 4d is provided. Inside the opening 4d, there is provided a cleaning unit 90 for cleaning the cut workpiece 11 or the like with cleaning water such as pure water. On the base 4, a housing (not illustrated) is provided. On a side surface on the front side (in the +Y direction) of the housing, there is provided a touch panel 92 that concurrently functions as an input section (that is, an input interface) for a worker to input instructions and a display section for displaying information for the worker

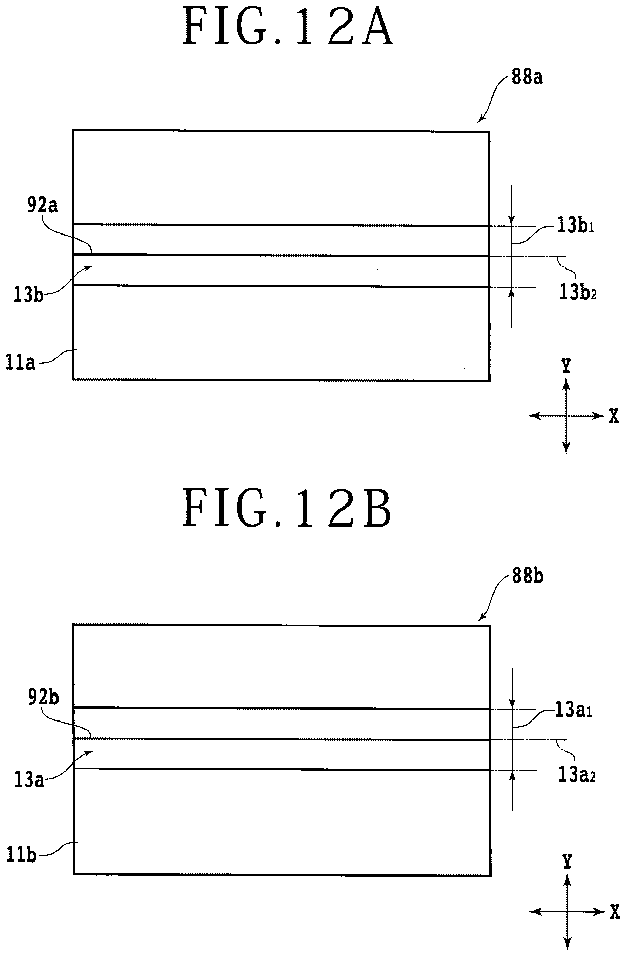

On the touch panel 92, for example, images captured by the upper side imaging units 86a and 86b and the lower side imaging unit 54 are displayed. On the touch panel 92, together with an image 88a captured by the upper side imaging unit 86a, a reference line 92a for the upper side imaging unit 86a is displayed by image processing (see FIG. 12A). The reference line 92a is a straight line that crosses the center of an imaging area of the upper side imaging unit 86a and that is substantially parallel to the X-axis direction. The upper side imaging unit 86a functions as an eye to directly observe the workpiece 11.

Similarly, on the touch panel 92, together with an image 88b imaged by the lower side imaging unit 54, a reference line 92b is displayed by image processing (see FIG. 12B). As with the reference line 92a, the reference line 92b is also a straight line that crosses the center of the imaging area of the lower side imaging unit 54 and that is substantially parallel to the X-axis direction. Similarly to the upper side imaging unit 86a, the lower side imaging unit 54 also functions as an eye to directly observe the workpiece 11. Note that the positions of origins of the upper side imaging unit 86a and the lower side imaging unit 54 are set beforehand in such a manner as to be aligned, and hence, the reference lines 92a and 92b are set beforehand in such a manner as to be aligned on an X-Y plane and hence would not be misaligned.

On the touch panel 92, in addition to the images captured by the lower side imaging unit 54 and the upper side imaging units 86a and 86b, processing conditions, a graphical user interface (GUI), and the like are displayed. The cutting apparatus 2 includes a controller 94 for controlling the touch panel 92 and other components. The controller 94 controls the suction source 14, the X-axis direction moving mechanism 26, the rotary drive source 30, the Y-axis direction moving mechanism 32, the Z-axis direction moving mechanism 42, the lower side imaging unit 54, the processing unit moving mechanisms 60, the first cutting unit 78a, the third cutting unit 78b, the upper side imaging units 86a and 86b, and the like.

The controller 94 includes, for example, a computer including a processing device such as a processor as represented by a central processing unit (CPU) and a storage device 96. The storage device 96 includes a main storage unit such as a dynamic random access memory (DRAM), a static random access memory (SRAM), and a read only memory (ROM) and an auxiliary storage unit such as a flash memory, a hard disk drive, and a solid state drive. The auxiliary storage unit stores software including predetermined programs. When the processing device is operated in accordance with this software, the functions of the controller 94 are implemented.

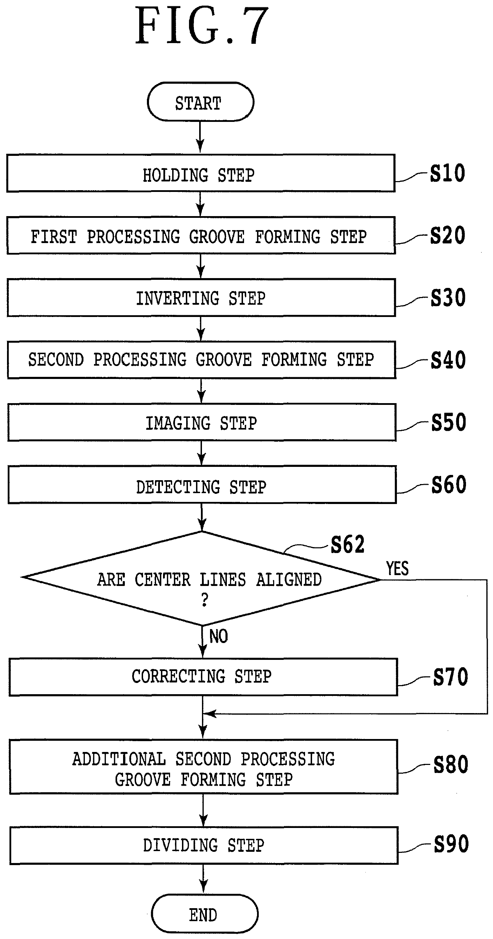

Next, a cutting method (processing method) for cutting the workpiece 11 by the cutting apparatus 2 will be described. FIG. 7 is a flowchart of the cutting method according to the first embodiment. In order to cut the workpiece 11, first, the face side 11a of the workpiece 11 is held under suction on the chuck table 10 via the tape 17, in a state in which the reverse side 11b is exposed upward (holding step S10). After the holding step S10, a first processing groove 13a is formed on the reverse side 11b by the first cutting unit 78a (first processing groove forming step S20).

FIG. 8 is a view illustrating the first processing groove forming step S20 according to the first embodiment. In the first processing groove forming step S20 according to the first embodiment, first, the lower side imaging unit 54 images the face side 11a, and alignment is performed. Next, the rotary drive source 30 is operated to make the projected dicing lines 13 extending along a first direction substantially parallel to the X-axis direction (that is, what is generally called θ alignment is performed). Then, the first cutting blade 84a is disposed on an extension of one projected dicing line 13, and a lower end of the first cutting blade 84a that is rotating at high speed (for example, 30,000 rpm) is positioned to a predetermined depth 23a that does not reach the face side 11a from the reverse side 11b.

In this state, while cutting water such as pure water is supplied to the first cutting blade 84a, the X-axis direction moving table 18 is processing fed (that is, moved along the X-axis direction), so that one first processing groove 13a (that is, what is generally called a half-cut groove) having the predetermined depth 23a is formed. The processing feed speed is, for example, 30 mm/s. Yet, the depth 23a may not be half of a thickness 11c of the workpiece 11. The depth 23a in the present embodiment is smaller than half the thickness 11c of the workpiece 11. For example, when the thickness 11c of the workpiece 11 is 100 µm, the depth 23a is set to 25 um. Yet, the depth 23a may adjusted as appropriate to such an extent that the depth 23a does not reach the face side 11a.

After the one first processing groove 13a is formed, the first cutting unit 78a is indexing fed only by a predetermined indexing feed amount, and cuts the reverse side 11b along another projected dicing line 13 extending along the first direction. After the reverse side 11b is similarly cut along all of the remaining projected dicing lines 13 extending along the first direction, the chuck table 10 is rotated by substantially 90 degrees to make the projected dicing lines 13 extending in a second direction orthogonal to the first direction substantially parallel to the X-axis direction. Then, the reverse side 11b is similarly cut along all of the projected dicing lines 13 extending along the second direction, so that the first processing grooves 13a are formed. After the workpiece 11 is cut along all of the projected dicing lines 13 on the reverse side 11b, the workpiece 11 is cleaned by the cleaning unit 90. Thereafter, the workpiece unit 21 is taken out from the cutting apparatus 2.

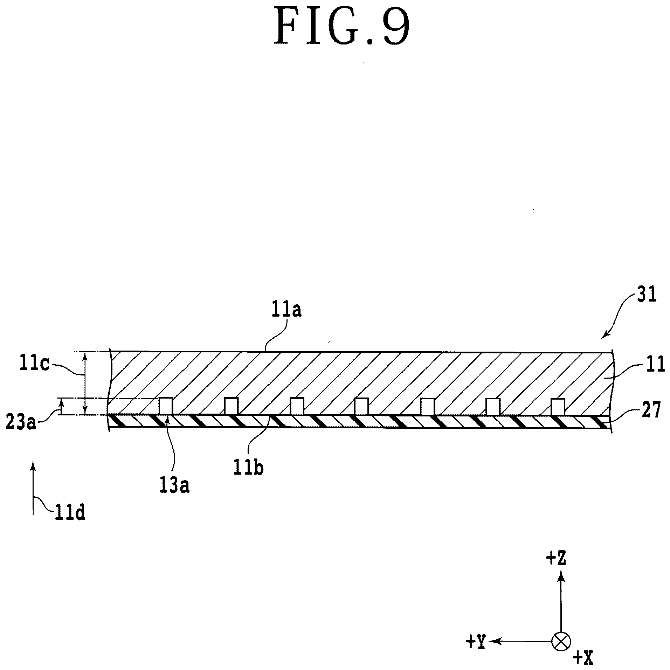

Following this, as illustrated in FIG. 9, a different tape (dicing tape) 27 is affixed to the reverse side 11b and the other surface of the frame 19, so that a workpiece unit 31 which has the reverse side 11b to which the tape 27 is affixed and which has the face side 11a exposed is formed (inverting step S30). FIG. 9 is a cross sectional view of the workpiece 11 that has undergone the inverting step S30 according to the first embodiment. Note that, in the case where the cutting apparatus 2 includes a tape replacement unit, the inverting step S30 may be performed inside the cutting apparatus 2 without the workpiece unit 21 being taken out from the cutting apparatus 2.

As with the tape 17, the tape 27 has a laminated structure including a base layer and an adhesive layer (glue layer) and is formed with a transparent material through which light in a predetermined wavelength band such as visible light can transmit. After the inverting step S30, the reverse side 11b of the workpiece 11 is held under suction on the chuck table 10, and the face side 11a is exposed upward. In this state, a second processing groove forming step S40 is performed with use of the first cutting unit 78a.

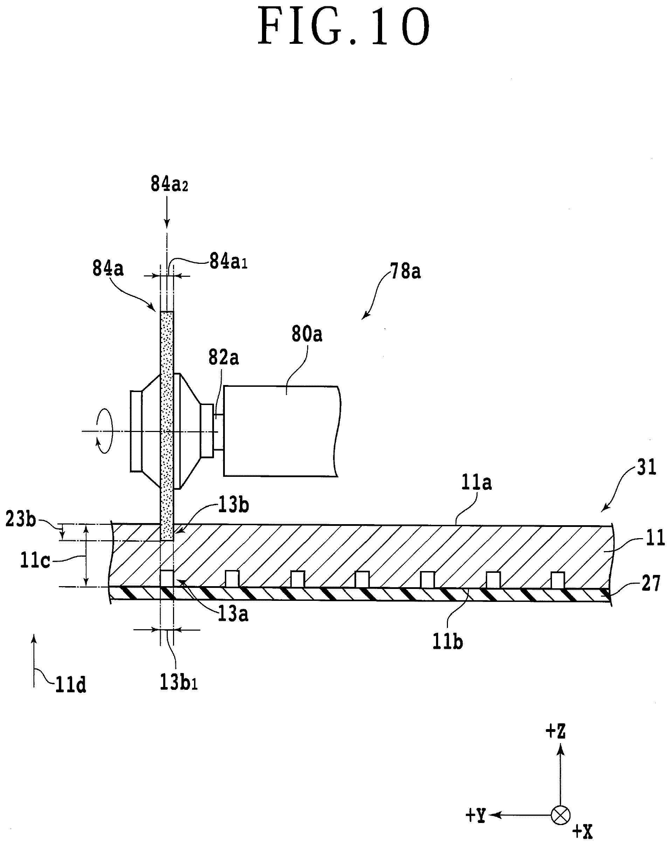

FIG. 10 is a view illustrating the second processing groove forming step S40 according to the first embodiment. Also in the second processing groove forming step S40, as in the first processing groove forming step S20, first, the aforementioned alignment and θ alignment are performed with use of the upper side imaging unit 86a. Next, the first cutting blade 84a is positioned on an extension of one projected dicing line 13, and the lower end of the first cutting blade 84a that is rotating at high speed is positioned to a predetermined depth 23b that does not reach the first processing groove 13a from the face side 11a.

Then, while cutting water is similarly supplied to the first cutting blade 84a, the X-axis direction moving table 18 is processing fed, so that only one second processing groove 13b that is positioned on an opposite side of the first processing groove 13a in the thickness direction 11d of the workpiece 11 and that has the predetermined depth 23b not reaching the first processing groove 13a is formed. Note that, also at the time of cutting the face side 11a, the rotational speed of the first cutting blade 84a is, for example, 30,000 rpm, and the processing feed speed is, for example, 30 mm/s.

As with the first processing groove 13a, the second processing groove 13b is also what is generally called a half-cut groove. Yet, the depth 23b may not be half the thickness 11c of the workpiece 11. The depth 23b in the present embodiment is smaller than half the thickness 11c of the workpiece 11. For example, in a case where the thickness 11c of the workpiece 11 is 100 µm, the depth 23b is set to 25 um. Yet, the depth 23b may be adjusted as appropriate, unless the depth 23b reaches the first processing groove 13a.

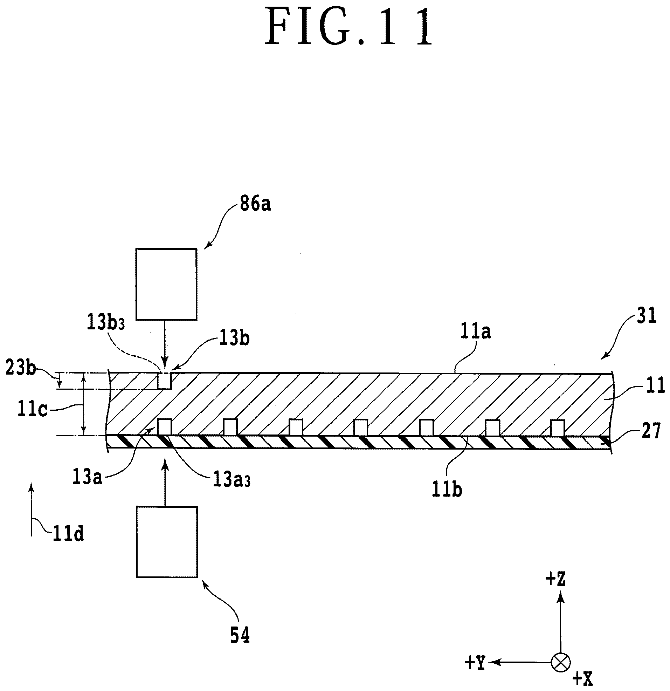

After the second processing groove forming step S40, the second processing groove 13b formed in the face side 11a is imaged by the upper side imaging unit 86a, and the first processing groove 13a formed in the reverse side 11b is imaged by the lower side imaging unit 54 (for example, the high magnification camera 58 and the lighting unit 58a) (imaging step S50). FIG. 11 is a view illustrating the imaging step S50 according to the first embodiment. The upper side imaging unit 86a focuses on the face side 11a that is exposed upward and images an elongated opening (that is, a predetermined line) 13b₃ of the second processing groove 13b that is formed in the face side 11a.

The opening 13b₃ is formed in the face side 11a and is also located at a position corresponding to that of the first processing groove 13a in the thickness direction 11d. In the imaging step S50, the lower side imaging unit 54 similarly focuses on the reverse side 11b via the tape 27 and images an elongated opening 13a₃ of the first processing groove 13a. FIG. 12A is a view illustrating an example of the image 88a of the face side 11a captured by the upper side imaging unit 86a. Note that, in the image 88a illustrated in FIG. 12A, a second center line 13b₂ of the second processing groove 13b and the reference line 92a are aligned.

The second center line 13b₂ is positioned at the center of the opening 13b₃ in the width direction in the second processing groove 13b and is substantially parallel to the longitudinal direction of the second processing groove 13b that is orthogonal to the width direction. The second center line 13b₂ substantially corresponds to a center 84a₂ in a thickness direction of a cutting edge of the first cutting blade 84a at the time of cutting (see FIG. 10).

FIG. 12B is a view illustrating an example of the image 88b of the reverse side 11b captured by the lower side imaging unit 54. In the image 88b illustrated in FIG. 12B, a first center line 13a₂ of the first processing groove 13a and the reference line 92b are aligned. The first center line 13a₂ is similarly positioned at the center of the opening 13a₃ in the width direction in the first processing groove 13a and is substantially parallel to the longitudinal direction of the first processing groove 13a that is orthogonal to the width direction.

The first center line 13a₂ substantially corresponds to the center 84a₂ of the cutting edge in the thickness direction of the first cutting blade 84a at the time of cutting (see FIG. 8). Note that, as described above, the reference line 92a and the reference line 92b are aligned with each other on the X-Y plane, and imaging the same area in the X-Y plane from different sides in the Z-axis direction allows the images 88a and 88b to be obtained.

After the imaging step S50, the controller 94 detects misalignment between the first processing groove 13a and the second processing groove 13b, in reference to the images 88a and 88b (detecting step S60). Specifically, in the detecting step S60, the controller 94 performs predetermined image processing on the images 88a and 88b and detects whether or not the position of the first center line 13a₂ of the first processing groove 13a and the position of the second center line 13b₂ of the second processing groove 13b are aligned in the X-Y plane (predetermined plane).

For example, first, by image processing, the positions (for example, the coordinates with the center point 12c₃ as the origin) of the first center line 13a₂ of the first processing groove 13a and the second center line 13b₂ of the second processing groove 13b are identified. Next, the length corresponding to the amount of misalignment between the first center line 13a₂ and the second center line 13b₂ is calculated. The length corresponding to one pixel in the image 88a and the image 88b is set beforehand according to the magnification or the like of the camera, and hence, the amount of misalignment is calculated in reference to the number of pixels between the first center line 13a₂ and the second center line 13b₂. Note that the programs for performing image processing and calculating the amount of misalignment are stored beforehand in the auxiliary storage unit of the storage device 96.

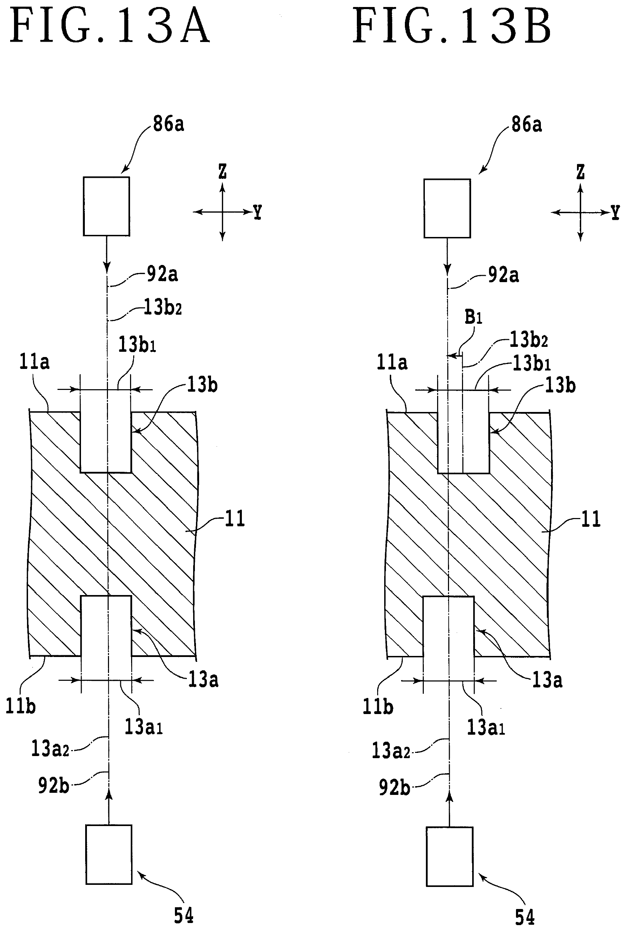

FIG. 13A is an enlarged cross sectional view illustrating part of the workpiece 11 in a case where the position of the first center line 13a₂ of the first processing groove 13a and the position of the second center line 13b₂ of the second processing groove 13b are aligned in the X-Y plane. In a case where the positions of the two center lines are aligned (YES in S62), the flow proceeds to an additional second processing groove forming step S80.

FIG. 13B is an enlarged cross sectional view illustrating part of the workpiece 11 in a case where the position of the first center line 13a₂ of the first processing groove 13a and the position of the second center line 13b₂ of the second processing groove 13b are misaligned in the X-Y plane. Misalignment of the positions of the two center lines can be caused by various factors. For example, in a case where there is a distortion in the shape of the alignment mark formed on the face side 11a, misalignment occurs between the position into which the first cutting blade 84a is to cut and the position where the workpiece 11 is actually cut.

However, in the present embodiment, the upper side imaging unit 86a images the face side 11a, and the lower side imaging unit 54 images the reverse side 11b, so that the first processing groove 13a and the second processing groove 13b are directly observed, making it possible to detect this misalignment. In FIG. 13B, the amount and direction of misalignment between the second center line 13b₂ and the reference line 92b in the Y-direction are represented by a vector B₁. In the detecting step S60, when the position of the first center line 13a₂ and the position of the second center line 13b₂ are not aligned in the X-Y plane, the controller 94 urges, by an alarm, the operator to correct the cutting position

In the present specification, the position of the first center line 13a₂ and the position of the second center line 13b₂ not being aligned (that is, being misaligned) in the X-Y plane signifies that the amount of misalignment between the position of the first center line 13a₂ and the position of the second center line 13b₂ in the Y-axis direction in the X-Y plane is greater than a first threshold (for example, 5 um). In a case where the amount of misalignment is greater than the first threshold, the controller 94 urges the operate to correct the cutting position. The worker, while looking at the image 88a, operates the touch panel 92 to move the reference line 92a (that is, the upper side imaging unit 86a) and align the reference line 92a with the second center line 13b₂ (correcting step S70).

In reference to the direction and distance of movement of the reference line 92b in the correcting step S70, the controller 94 detects the amount and direction of misalignment in the cutting position (the vector B₁ in FIG. 13B) and stores them in the storage device 96. At the time of performing cutting after the correcting step S70, the controller 94 controls the processing unit moving mechanism 60 in such a manner as to cancel the amount and direction of misalignment, to correct the position of the center 84a₂ of the first cutting blade 84a (that is, the processing position of the first cutting unit 78a). Specifically, by the amount and direction of misalignment being added to a predetermined indexing feed amount, the indexing feed amount is adjusted. This allows the position of the first center line 13a₂ and the position of the second center line 13b₂ to be aligned in the X-Y plane in subsequent cutting (that is, the additional second processing groove forming step S80).

The position of the first center line 13a₂ and the position of the second center line 13b₂ being aligned in the X-Y plane after the correcting step S70 means that the amount of misalignment between the position of the first center line 13a₂ and the position of the second center line 13b₂ in the X-Y plane is equal to or smaller than a second threshold (for example, 1 µm) that is smaller than the first threshold. Note that, in FIG. 13B, in order to simplify the description, the reference line 92b and the first center line 13a₂ of the first processing groove 13a are aligned, but the reference line 92b and the first center line 13a₂ may be misaligned.

In a case where the reference line 92b and the first center line 13a₂ are misaligned and the reference line 92a and the second center line 13b₂ are misaligned, both the amount and direction of misalignment between the first center line 13a₂ and the reference line 92b and the amount and direction of misalignment between the second center line 13b₂ and the reference line 92a are used for correcting the processing position. In either case, the amount and direction of misalignment between the position of the second center line 13b₂ with respect to the position of the first center line 13a₂ are detected in the detecting step S60, and the amount and direction of misalignment are corrected in the correcting step S70.

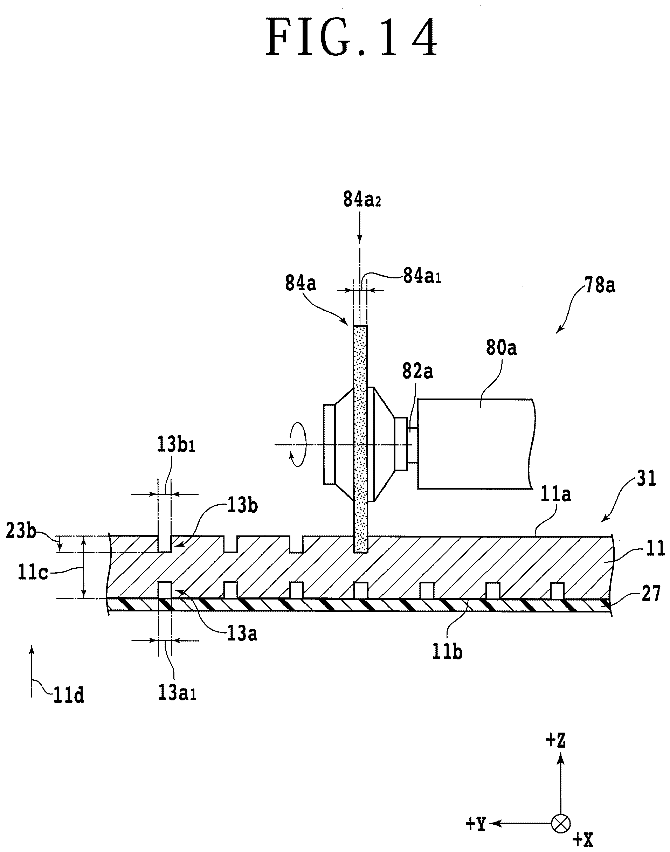

FIG. 14 is a view illustrating the additional second processing groove forming step S80. In the additional second processing groove forming step S80, the first cutting unit 78a is sequentially indexing fed in the Y-axis direction from the position of the second processing groove 13b formed in the second processing groove forming step S40, to additionally form four second processing grooves 13b. In this manner, when a total of five second processing grooves 13b are formed, a dividing step S90 of dividing the workpiece 11 in such a manner as to connect to each other the first processing groove 13a and the second processing groove 13b that are formed in corresponding positions in the thickness direction 11d is started. FIG. 15 is a view illustrating the dividing step S90 according to the first embodiment.

In the dividing step S90, the center 84b₂ of the blade thickness 84b₁ of the third cutting blade 84b is positioned within the widths 13a₁ and 13b₁, and the lower end of the third cutting blade 84b that is rotating at high speed is positioned on the face side 11a relative to the predetermined depth 23a. By cutting water being supplied and the chuck table 10 being processing fed in this state, the workpiece 11 is divided. In the dividing step S90, the rotational speed of the third cutting blade 84b is, for example, 30,000 rpm, and the processing feed speed is, for example, 30 mm/s.

In the present embodiment, when the workpiece 11 is to be cut by the third cutting unit 78b along the first second processing groove 13b, a sixth second processing groove 13b is formed by the first cutting unit 78a. That is, there is a time zone in which the additional second processing groove forming step S80 and the dividing step S90 are performed in parallel. After the second processing grooves 13b are formed along all of the remaining projected dicing lines 13 extending along the first direction, and further, the workpiece 11 is divided in such a manner that the first processing grooves 13a and the second processing grooves 13b formed along the first direction are connected to each other, the chuck table 10 is rotated by substantially 90 degrees.

Thereafter, the second processing grooves 13b are similarly formed along all of the projected dicing lines 13 extending along the second direction, and further, the workpiece 11 is divided in such a manner that first processing groove 13a and the second processing groove 13b formed along the second direction are connected to each other. In the present embodiment, processing of the workpiece 11 is proceeded in such a manner that the third cutting unit 78b follows the first cutting unit 78a in the Y-axis direction, but the dividing step S90 may be started after the additional second processing groove forming step S80 is completed. For example, in a case where the workpiece 11 includes a substrate formed with brittle materials such as glass that is vulnerable compared to a single-crystal substrate formed with silicon, starting the dividing step S90 after the additional second processing groove forming step S80 is completed can reduce occurrence of chipping, cracking, and other similar problems.

As described so far, in the first embodiment, even in a case where the position of the first center line 13a₂ and the position of the second center line 13b₂ are misaligned, the workpiece 11 can be cut after correction is made such that the positions of the first center line 13a₂ and the second center line 13b₂ are aligned in the cutting to be performed along the next projected dicing line 13. In addition, according to the abovementioned processing method, by the first processing grooves 13a and the second processing grooves 13b being directly observed, even if there is any distortion in the shape of the alignment marks, impact that could be caused by the distortion in the shape of the alignment marks may be reduced. In this manner, compared to the case in which the first processing grooves 13a and the second processing grooves 13b are not directly observed, the processing accuracy for the workpiece 11 can be improved. That is, the first center line 13a₂ of the first processing groove 13a and the second center line 13b₂ of the second processing groove 13b can be aligned with higher accuracy.

### (First modification)

In the first embodiment, the imaging step S50 and the detecting step S60 are each performed only once, but they may each be performed two or more times. Specifically, the imaging step S50 and the detecting step S60 may be performed every time a predetermined number of (for example, five) second processing grooves 13b are formed. In a case where the positions of the two center lines are detected to be misaligned as a result of the detecting step S60, the correcting step S70 is performed. This results in a longer processing time but can assure processing with further higher accuracy.

### (Second modification)

Incidentally, in the first processing groove forming step S20 according to the first embodiment, the first cutting unit 78a is used as both the first and second processing units. However, the first processing groove forming step S20 may be performed with use of another cutting apparatus similar to the cutting apparatus 2. In a case where the first processing groove forming step S20 is to be performed with use of another cutting apparatus, the chuck table to be provided in the other cutting apparatus may be the chuck table 10 described above, or may be a chuck table in which a porous plate formed with porous ceramic is fixed to a circular plate-shaped recessed portion of a frame body made of metal.

In a case where a porous plate formed with porous ceramic is to be used as the chuck table, in order to image the face side 11a from the reverse side 11b, an infrared camera unit including a predetermined optical system and an imaging element that can photoelectrically convert infrared light is used as the upper side imaging unit. After the first processing groove forming step S20 is performed with use of the other cutting apparatus, in the second processing groove forming step S40 and the additional second processing groove forming step S80, the first cutting unit 78a is used as the second processing unit, and in the dividing step S90, the third cutting unit 78b is used as the third processing unit.

In this manner, in a case where the cutting unit to be used is different between the first processing groove forming step S20 and the second processing groove forming step S40, the cutting blade is mounted to the spindle normally in one of the cutting units but abnormally in the other of the cutting units (that is, the cutting blade is mounted to the spindle in such a manner that the side surface of the cutting blade is oblique to the spindle) in some cases. As a result, the position of the first center line 13a₂ and the position of the second center line 13b₂ are misaligned in the X-Y plane is some cases. However, as described in the first embodiment, this misalignment can be corrected through performance of the correcting step S70.

### (Second embodiment)

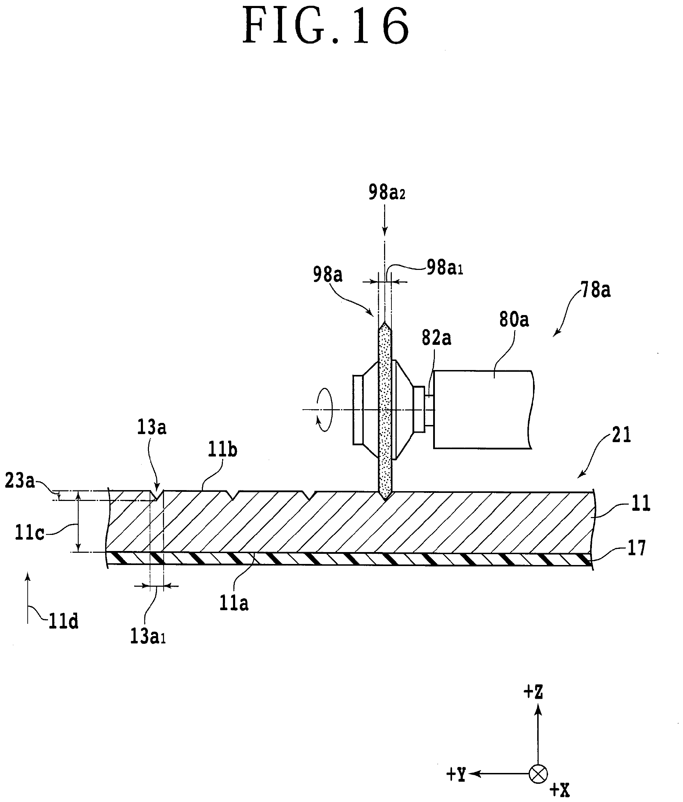

Next, a second embodiment will be described with reference to FIGS. 16 to 20. Also in the second embodiment, the abovementioned cutting apparatus 2 is used to process the workpiece 11 in line with the flow illustrated in FIG. 7. Hence, description that overlaps with those for the first embodiment will be omitted. In the second embodiment, a cutting blade 98a (see FIG. 16) that is mounted to the first cutting unit (first processing unit, second processing unit) 78a has a V-shaped outer circumferential end portion as viewed in cross section that passes through the center of the cutting blade 98a in the radial direction. The cutting blade 98a having the V-shaped outer circumferential portion is the difference from the first embodiment.

That is, in the cutting blade 98a, a center 98a₂ of the blade thickness 98a₁ is most protruding in the radial direction, and sloping surfaces are formed toward the two circular annular surfaces of the cutting blade 98a from the center 98a₂ of the blade thickness 98a₁. Also in the processing method according to the second embodiment, the first processing groove forming step S20 is performed after the holding step S10.

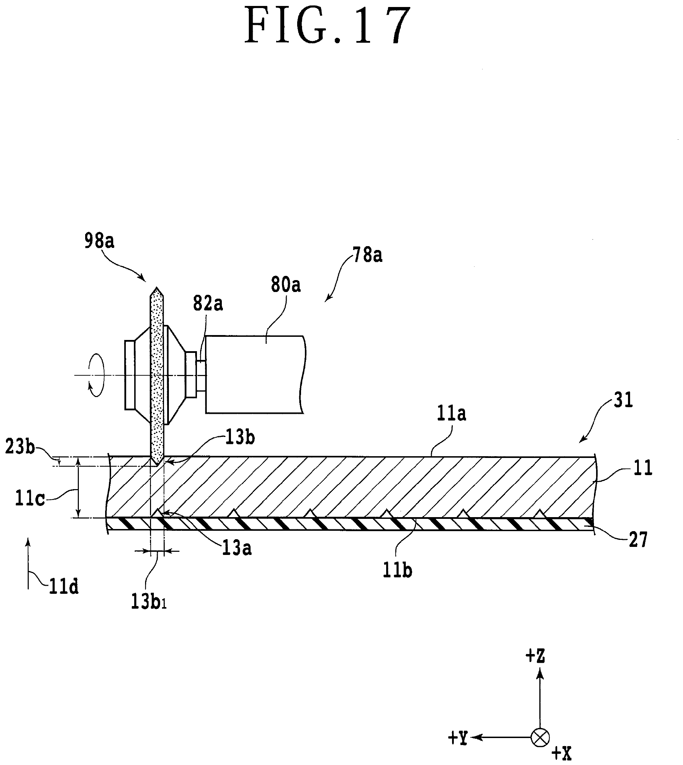

FIG. 16 is a view illustrating the first processing groove forming step S20 according to the second embodiment. The bottom portion of the first processing groove 13a formed in the first processing groove forming step S20 has a V-shape as viewed in cross section that is perpendicular to the longitudinal direction of the first processing groove 13a, according to the shape of the outer circumferential end portion of the cutting blade 98a. After the first processing grooves 13a are formed along all of the projected dicing lines 13 in the first processing groove forming step S20, the second processing groove forming step S40 is performed after the inverting step S30 (see FIG. 9) is performed. FIG. 17 is a view illustrating the second processing groove forming step S40 according to the second embodiment.

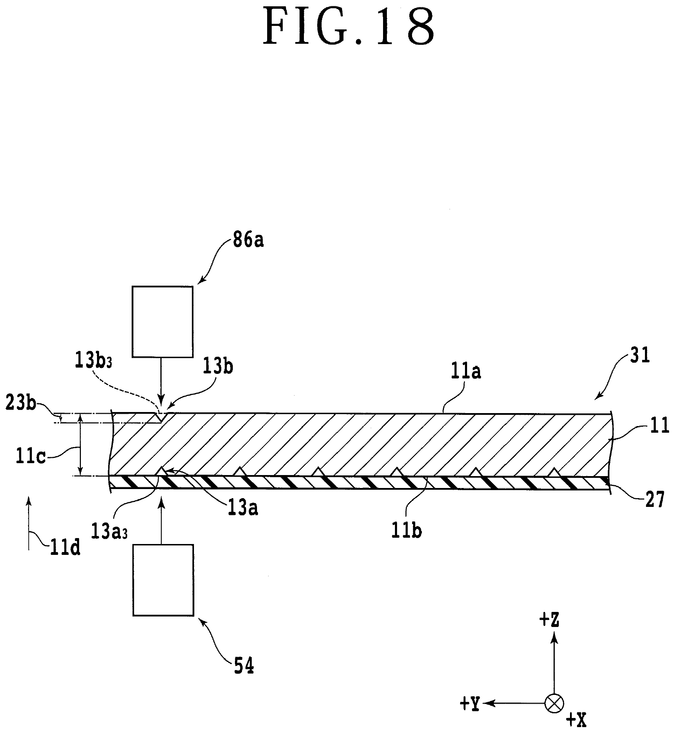

The bottom portion of the second processing groove 13b also has a V-shape as viewed in cross section. After one second processing groove 13b is formed in the second processing groove forming step S40, the imaging step S50 is performed. FIG. 18 is a view illustrating the imaging step S50 according to the second embodiment. After the imaging step S50, the detecting step S60 is performed. In the detecting step S60, whether or not the position of the first center line 13a₂ of the first processing groove 13a and the second center line 13b₂ of the second processing groove 13b are aligned in the X-Y plane is detected. In a case where the position of the first center line 13a₂ and the position of the second center line 13b₂ are aligned in the X-Y plane, the flow proceeds to the additional second processing groove forming step S80. In a case where the position of the first center line 13a₂ and the position of the second center line 13b₂ are not aligned in the X-Y plane, the flow proceeds to the additional second processing groove forming step S80 after the correcting step S70 is performed.

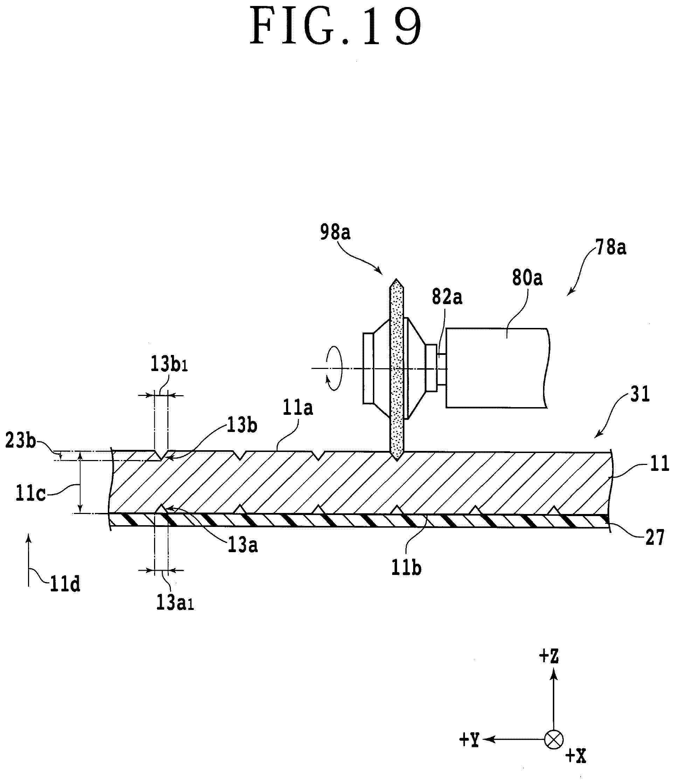

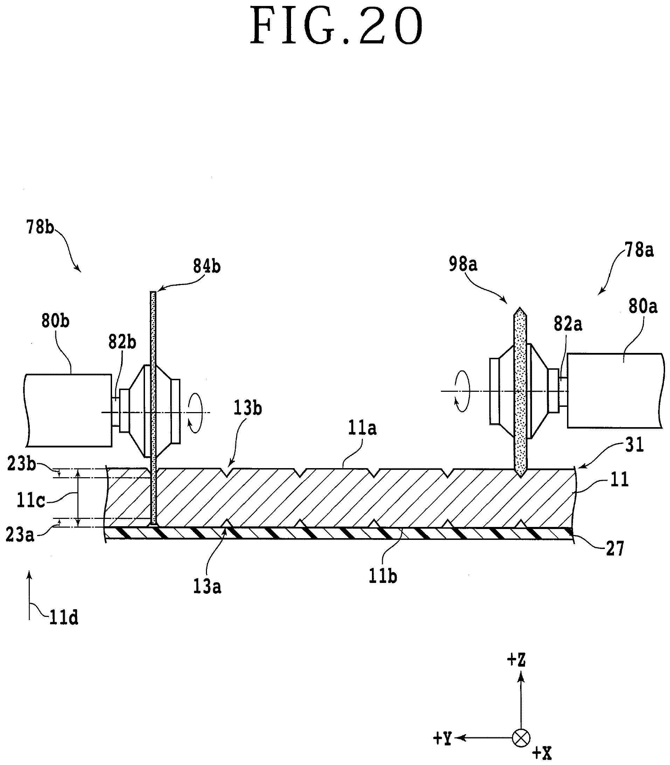

FIG. 19 is a view illustrating the additional second processing groove forming step S80 according the second embodiment. Since the correcting step S70 is performed, in the additional second processing groove forming step S80, the position of the first center line 13a₂ and the position of the second center line 13b₂ can be aligned in the X-Y plane. Also in the second embodiment, when five second processing grooves 13b are formed, the dividing step S90 is started. FIG. 20 is a view illustrating the dividing step S90 according to the second embodiment. Yet, as described above, the dividing step S90 may be started after the additional second processing groove forming step S80 is completed.

Also in the second embodiment, compared to the case in which the first processing grooves 13a and the second processing grooves 13b are not directly observed, processing accuracy for the workpiece 11 can be improved. In addition, according to the V-shape of the processing grooves, chamfered portions can be formed on the outer circumferential portions on the face side 11a and the reverse side 11b of the device chip (not illustrated) that is to be eventually manufactured. Forming the chamfered portions reduces occurrence of cracks and chipping in the outer circumferential portions of the face side 11a and the reverse side 11b compared to the case in which no chamfered portions are formed. Note that the first and second modifications can also be applied to the second embodiment.

### (Third modification)

At least one of the cutting blade (not illustrated) mounted to the cutting unit (first processing unit) that is used to perform the first processing groove forming step S20 or the cutting blade mounted to the first cutting unit (second processing unit) 78a may have a V-shaped outer circumferential end portion as viewed in cross section. In this case, at least one of the processing grooves formed by the cutting blade having the V-shaped outer circumferential end portion as viewed in cross section, that is, at least one of the first processing groove 13a or the second processing groove 13b is processed in such a manner as to have a V-shape as viewed in cross section.

### (Third embodiment)

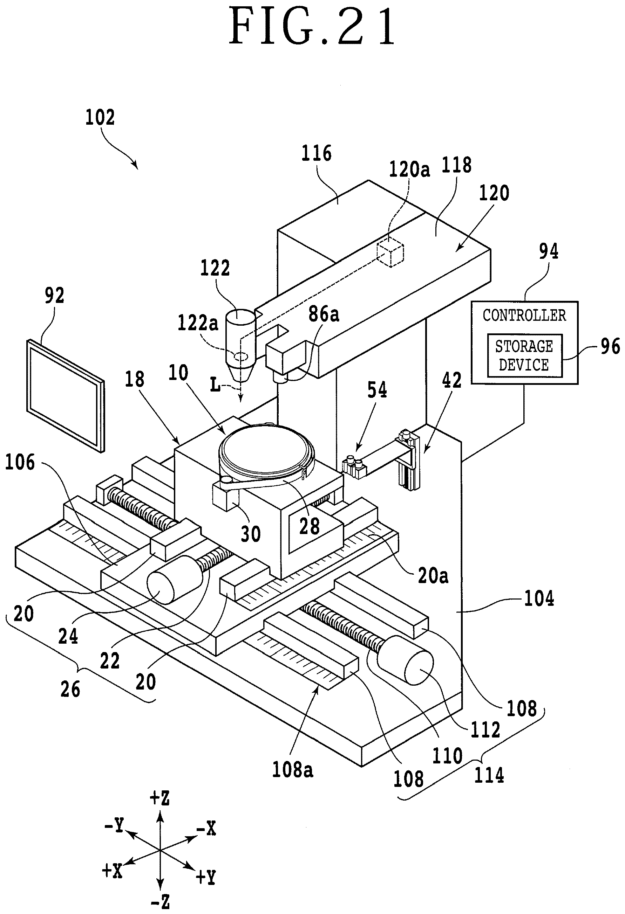

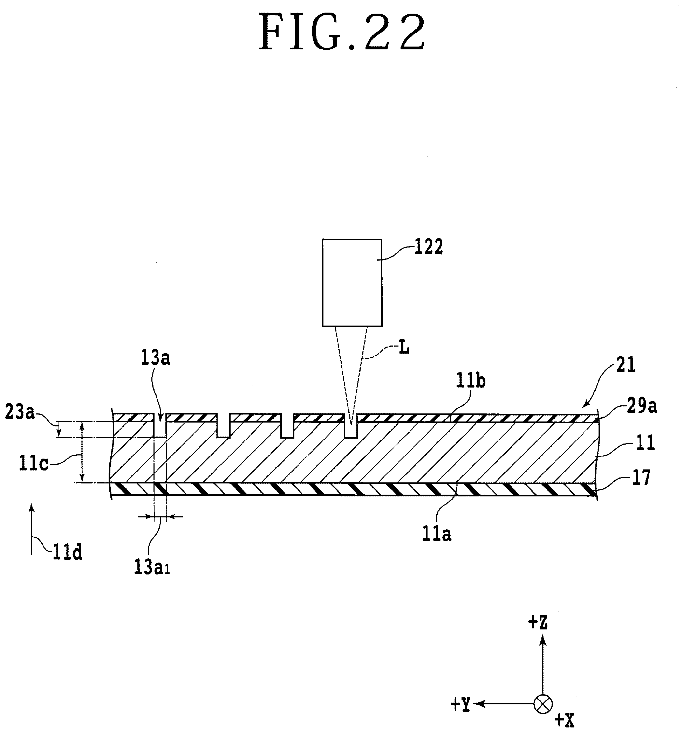

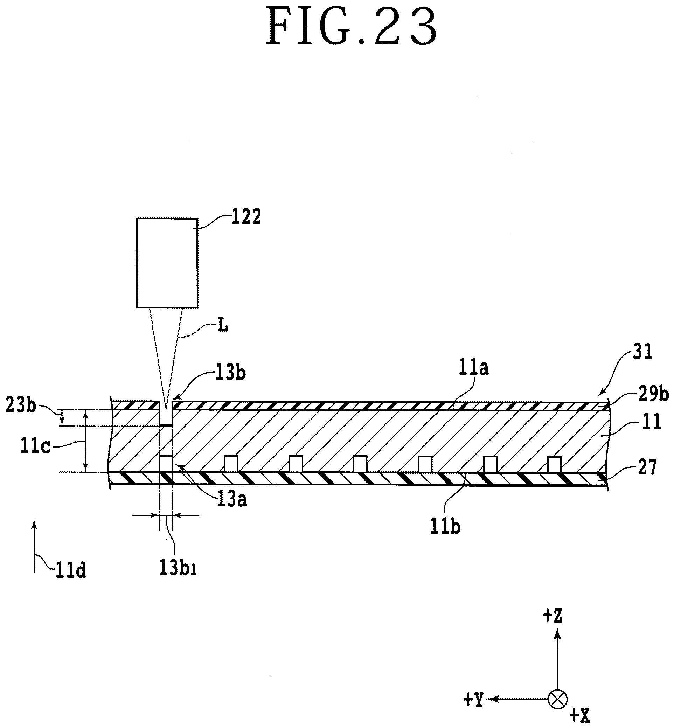

Next, a third embodiment will be described with reference to FIGS. 21 to 26. In the third embodiment, the first processing grooves 13a (see FIG. 22) and the second processing grooves 13b (see FIG. 23) are formed by ablation processing being performed on the workpiece 11 with application of a laser beam L (see FIG. 21). FIG. 21 is a perspective view illustrating a laser processing apparatus 102 according to the third embodiment. Note that components identical with or corresponding to those of the cutting apparatus 2 are denoted by identical reference signs and redundant description is omitted.

In the laser processing apparatus 102, the lower side imaging unit 54 is fixed to a stationary base 104. However, the lower side imaging unit 54 may be provided in such a manner as to be movable in the X-axis direction or the Y-axis direction. On the upper side of the stationary base 104, the X-axis direction moving table 18 is provided. The X-axis direction moving table 18 is disposed in such a manner that the lower side imaging unit 54 can enter the space 18d from an area located on an opposite side of the side plate 18b of the X-axis direction moving table 18.

The X-axis direction moving table 18 is movable along the X-axis direction by the X-axis direction moving mechanism 26. The pair of X-axis guide rails 20 are fixed on a Y-axis moving table 106. The Y-axis moving table 106 is attached, in a slidable manner, on a pair of Y-axis guide rails 108 that are fixed to the upper surface of the stationary base 104. In the vicinity of the Y-axis guide rails 108, there is provided a Y-axis linear scale 108a that is used for detecting the position of the Y-axis moving table 106 in the Y-axis direction. On a lower surface side of the Y-axis moving table 106, a nut portion (not illustrated) is provided.

To the nut portion, a screw shaft 110 that is disposed substantially parallel to the Y-axis guide rails 108 is coupled in a rotatable manner through balls (not illustrated). To one end portion of the screw shaft 110, a motor 112 is coupled. The Y-axis guide rails 108, the screw shaft 110, the motor 112, and the like constitute a Y-axis direction moving mechanism 114. At a position adjacent to the lower side imaging unit 54 in the -Y direction, a column 116 is provided in such a manner as to protrude upward from the upper surface of the stationary base 104. The column 116 is provided with a casing 118 that has a longitudinal portion extending substantially parallel to the X-axis direction.

In the casing 118, at least part of a laser application unit 120 is disposed. The laser application unit (first processing unit, second processing unit) 120 can emit the pulsed laser beam L having a wavelength (for example, 355 nm) absorbable by the workpiece 11. The laser application unit 120 includes a laser oscillator 120a and the like. On the distal end portion of the laser application unit 120 in the +X direction, a head portion 122 including a condenser lens 122a is provided.

The laser beam emitted from the laser oscillator 120a is condensed by the condenser lens 122a and is applied toward the lower side from the head portion 122. In FIG. 21, the laser beam L emitted toward the lower side from the head portion 122 is indicated by an arrow with broken lines. At a position adjacent to the head portion 122 in the distal end portion of the casing 118, the upper side imaging unit 86a is provided. The upper side imaging unit 86a and the lower side imaging unit 54 (for example, the high magnification camera 58 and the lighting unit 58a) that are each illustrated in FIG. 21 are aligned in the positions in the Y-axis direction but misaligned in the positions in the X-axis direction. Hence, in the workpiece 11 held under suction on the chuck table 10, the positions corresponding with each other in the thickness direction 11d cannot be observed at the same time.

However, the positional relations of the upper side imaging unit 86a and the lower side imaging unit 54 with respect to the chuck table 10 are defined in advance Accordingly, if the X-axis direction moving table 18 is moved along the X-axis direction, the same area in the X-Y plane with respect to the center point 12c₃ of the holding member 12 (see FIG. 3) can be observed by both the upper side imaging unit 86a and the lower side imaging unit 54. In this way, the reference line 92a displayed in the image 88a and the reference line 92b displayed in the image 88b are positioned in the aligned coordinate positions in the images, and thus are not misaligned with respect to each other.

Also in the third embodiment, the workpiece 11 is processed in line with the flow illustrated in FIG. 7.

In the processing method according to the third embodiment, prior to the holding step S10, a first protective film 29a (see FIG. 22) formed with water-soluble resin is provided on the reverse side 11b. Next, after the face side 11a is held under suction on the chuck table 10 (that is, after the holding step S10), the first processing groove forming step S20 is performed. FIG. 22 is a view illustrating the first processing groove forming step S20 according to the third embodiment In the first processing groove forming step S20, a focused spot of the laser beam L is positioned to the reverse side 11b, and, for example, laser processing is performed under the following processing conditions.
Wavelength of laser beam: 355 nm
Average output: 2 W
Repetitive frequency of pulse: 200 kHz
Processing feed speed: 400 mm/s
Pass count: 1

In the first processing groove forming step S20, after the first processing grooves 13a are formed along all of the projected dicing lines 13, a spinner cleaner (not illustrated) is used to clean and remove the first protective film 29a. Next, in the inverting step S30, the workpiece unit 31 is formed, the tape 27 is affixed to the reverse side 11b, and a second protective film 29b (see FIG. 23) is formed on the face side 11a.

As with the first protective film 29a, the second protective film 29b also has the function of preventing debris (for example, a melted mass of the material configuring the workpiece 11) generated by ablation processing from adhering to the processed surface. The second protective film 29b and the abovementioned first protective film 29a can be formed by first applying and then drying a solution including water-soluble resin such as polyvinylpyrrolidone (PVP) and polyvinyl alcohol (PVA) and a light absorbing agent.

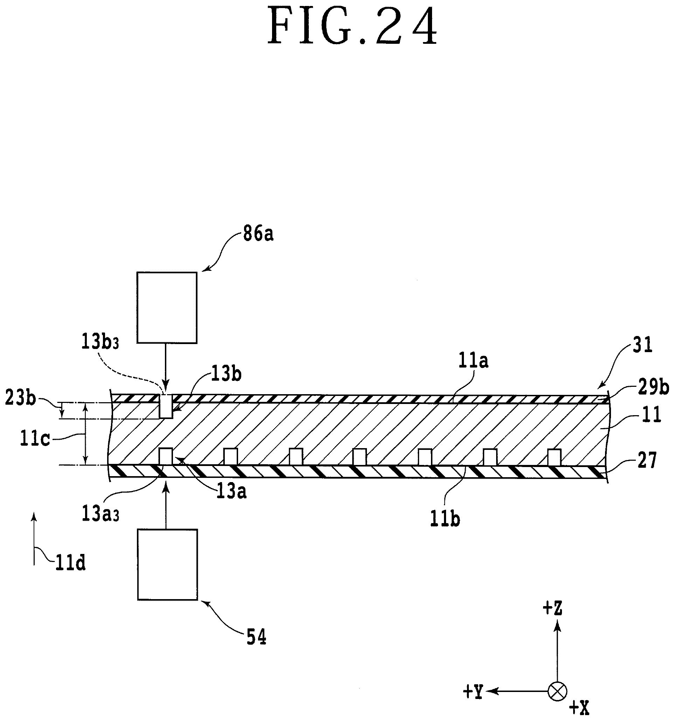

After the second protective film 29b is formed on the face side 11a, the second processing groove forming step S40 is performed. FIG. 23 is a view illustrating the second processing groove forming step S40 according to the third embodiment. In the second processing groove forming step S40, one second processing groove 13b is formed under the abovementioned processing conditions. After the second processing groove forming step S40, the imaging step S50 is performed. FIG. 24 is a view illustrating the imaging step S50 according to the third embodiment. In the imaging step S50, the first processing groove 13a and the second processing groove 13b that are formed in corresponding positions in the thickness direction 11d are imaged.

After the imaging step S50, the detecting step S60 is performed. In the detecting step S60, whether or not the position of the first center line 13a₂ of the first processing groove 13a and the second center line 13b₂ of the second processing groove 13b are aligned in the X-Y plane (predetermined plane) is detected. In a case where the position of the first center line 13a₂ of the first processing groove 13a and the position of the second center line 13b₂ of the second processing groove 13b are aligned in the X-Y plane, the flow proceeds to the additional second processing groove forming step S80. In contrast, in a case where the position of the first center line 13a₂ of the first processing groove 13a and the position of the second center line 13b₂ of the second processing groove 13b are not aligned in the X-Y plane, the flow proceeds to the additional second processing groove forming step S80 after the correcting step S70 is performed.

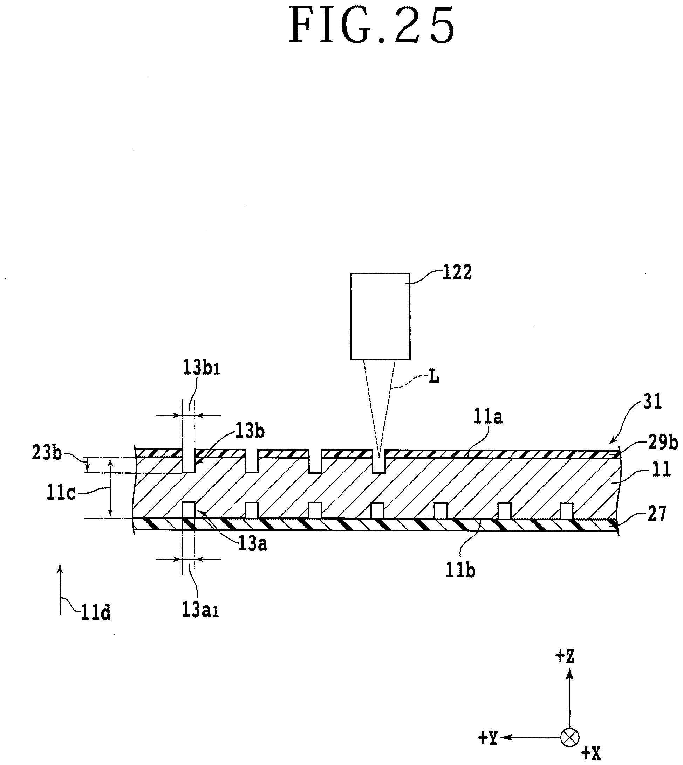

FIG. 25 is a view illustrating the additional second processing groove forming step S80 according to the third embodiment. Since the correcting step S70 is performed, in the additional second processing groove forming step S80, the position of the first center line 13a₂ of the first processing groove 13a and the position of the second center line 13b₂ of the second processing groove 13b can be aligned in the X-Y plane. After the second processing grooves 13b are formed along all of the projected dicing lines 13, a spinner cleaner (not illustrated) is used to clean and remove the second protective film 29b. Then, the workpiece unit 31 is delivered to the cutting apparatus 2. In the cutting apparatus 2, the workpiece 11 is cut by the third cutting unit 78b in such a manner that the first processing groove 13a and the second processing groove 13b are connected to each other (dividing step S90).

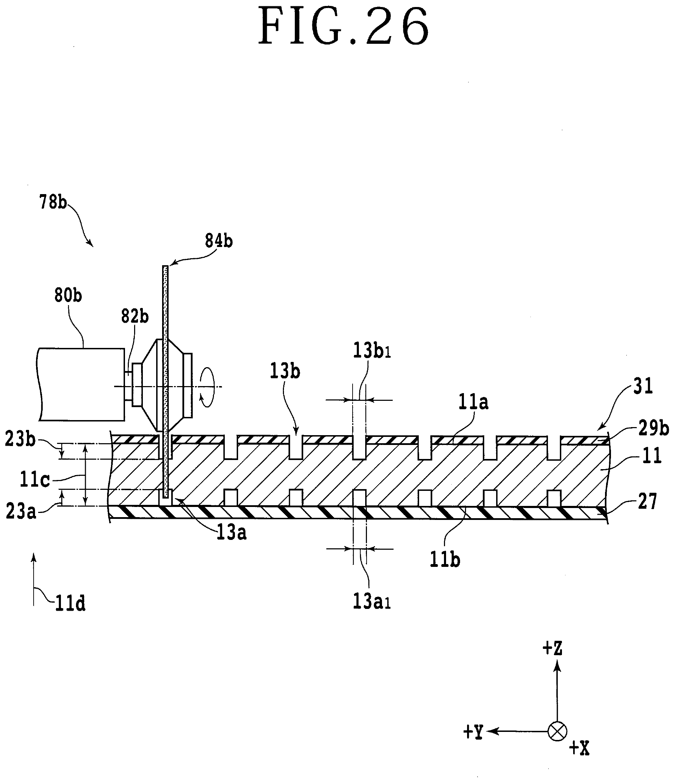

FIG. 26 is a view illustrating the dividing step S90 according to the third embodiment. Also in the third embodiment, compared to the case in which the first processing grooves 13a and the second processing grooves 13b are not directly observed, the processing accuracy for the workpiece 11 can be improved. Incidentally, in the third embodiment, the laser application unit 120 is used as the first and second processing units. Yet, the laser application unit 120 may be used as at least one of the first processing unit or the second processing unit. For example, when the laser application unit 120 is used as one of the first processing unit and the second processing unit, the first cutting unit 78a is used as the other of the first processing unit and the second processing unit.

### (Fourth modification)

In the dividing step S90 according to the abovementioned embodiments and the modifications, the workpiece 11 is cut by the third cutting unit 78b that includes a relatively thin blade thickness 84b₁. Yet, the dividing step S90 may by performed by performance of ablation processing on the workpiece 11.

### (Fourth embodiment)

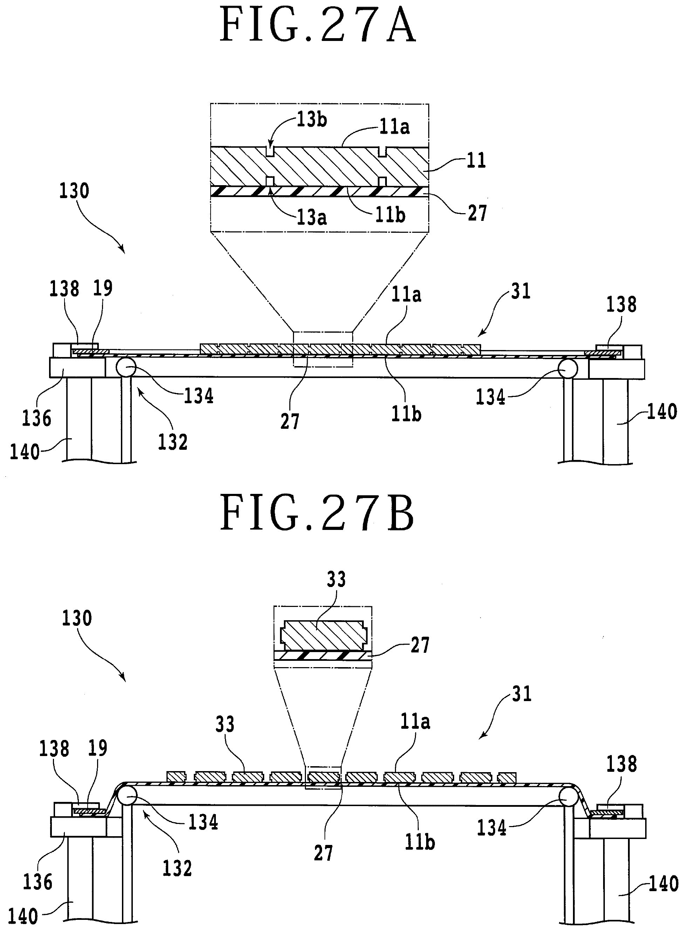

Next, a fourth embodiment will be described with reference to FIGS. 27A and 27B. In the fourth embodiment, the dividing step S90 is performed by an expanding apparatus 130. Use of the expanding apparatus 130 is the difference from the abovementioned embodiments and the modification. FIG. 27A is a partially cross sectional side view of the expanding apparatus 130 and other components. The expanding apparatus 130 has a cylindrical drum 132 having a larger diameter than the workpiece 11. On an upper end portion of the drum 132, a plurality of rollers 134 are provided at substantially equal intervals along a circumferential direction of the drum 132.

On an outer side of the drum 132 in a radial direction thereof, an annular frame support base 136 is provided. On an upper surface side of the frame support base 136, there are provided a plurality of clamps 138 that each clamp the frame 19 of the workpiece unit 31 placed on the frame support base 136. Further, the frame support base 136 is supported by a plurality of leg portions 140 that are disposed at substantially equal intervals along the circumferential direction of the frame support base 136. The leg portions 140 can be lifted and lowered by lifting/lowering mechanisms such as an air cylinder.

In the dividing step S90, as illustrated in FIG. 27A, after the upper end of the drum 132 and the level of the upper surface of the frame support base 136 are positioned to substantially the same height, the workpiece unit 31 that has undergone the additional second processing groove forming step S80 is placed on the drum 132 and the frame support base 136. The workpiece 11 already has the first processing grooves 13a and the second processing grooves 13b formed in such a manner that the distance between the bottom portion of the first processing groove 13a and the bottom portion of the second processing groove 13b is equal to or shorter than a predetermined distance (for example, equal to or shorter than 50 pm).

When the lifting/lowering mechanisms are operated and the leg portions 140 are lowered after the workpiece unit 31 is placed, the frame support base 136 is lowered with respect to the drum 132. As a result, as illustrated in FIG. 27B, the tape 27 is expanded in the radial direction, and an undivided region between the first processing groove 13a and the second processing groove 13b in the thickness direction 11d is divided. FIG. 27B is a view illustrating the dividing step S90 according to the fourth embodiment. In the dividing step S90, the expanding apparatus 130 is used to divide the workpiece 11 into a plurality of device chips 33. Expanding the space between the device chips 33 simultaneously with dividing has the advantage that the subsequent pickup step for the device chips 33 becomes easy.

### (Fifth embodiment)

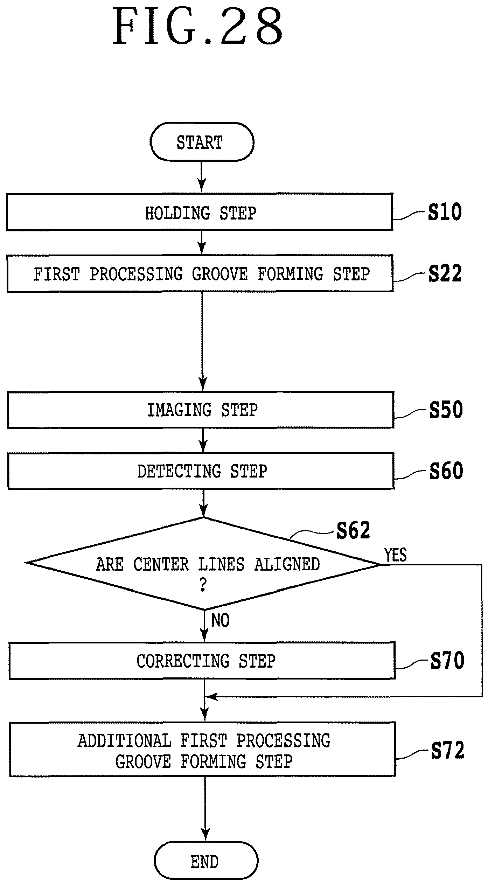

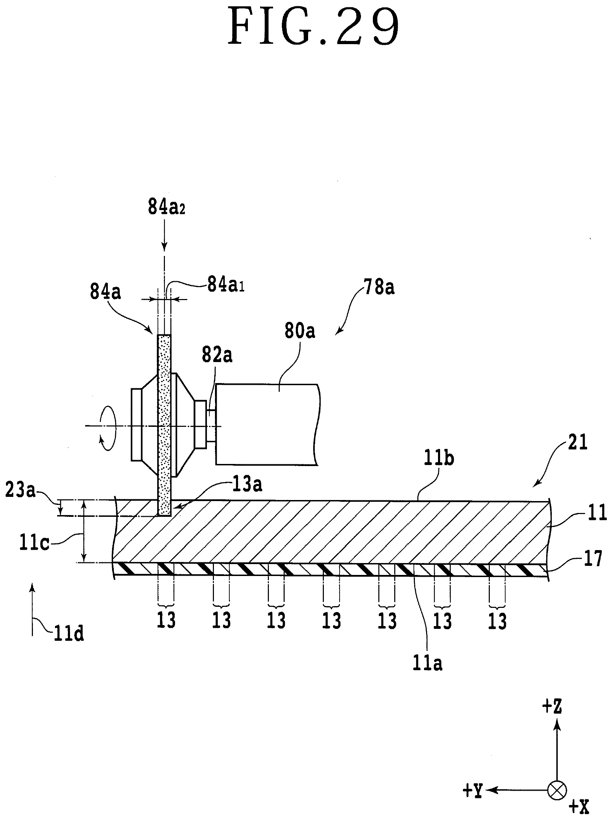

Next, a fifth embodiment will be described with reference to FIGS. 28 to 31B. In the fifth embodiment, when the first processing groove 13a is to be formed on the reverse side 11b with use of the cutting apparatus 2 described above, the imaging step S50, the detecting step S60, the correcting step S70, and other relevant steps are performed. Performing such steps in forming the first processing groove 13a is the difference from the abovementioned embodiments. FIG. 28 is a flowchart illustrating the processing method according to the fifth embodiment. In the fifth embodiment, only one first processing groove 13a is formed on the reverse side 11b in a first processing groove forming step S22 following the holding step S10 (see FIG. 29). FIG. 29 is a view illustrating the first processing groove forming step S22 according to the fifth embodiment.

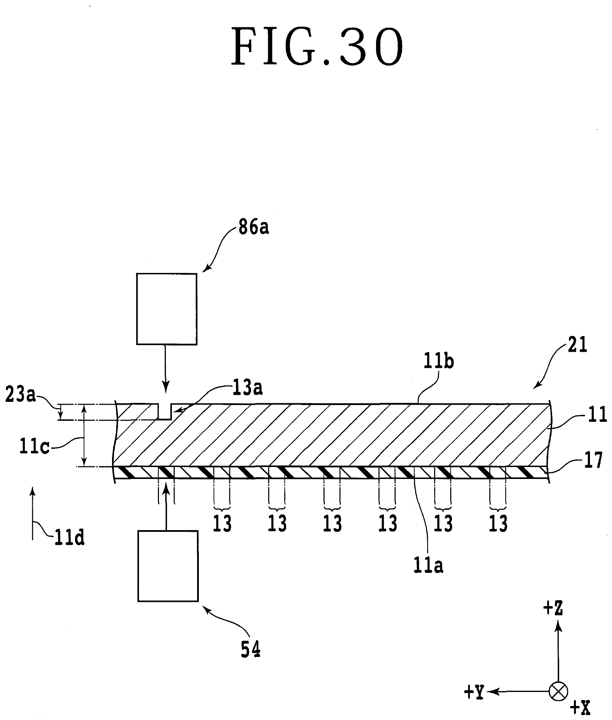

After the first processing groove forming step S22, as illustrated in FIG. 30, the first processing groove 13a is imaged by the upper side imaging unit (first imaging unit) 86a, and the projected dicing line (predetermined line) 13 formed in a position corresponding to that of the first processing groove 13a in the thickness direction 11d is imaged by the lower side imaging unit (second imaging unit) 54. FIG. 30 is a view illustrating the imaging step S50 according to the fifth embodiment. Note that, in the fifth embodiment, the upper side imaging unit 86a functions as the first imaging unit, while the lower side imaging unit 54 functions as the second imaging unit.

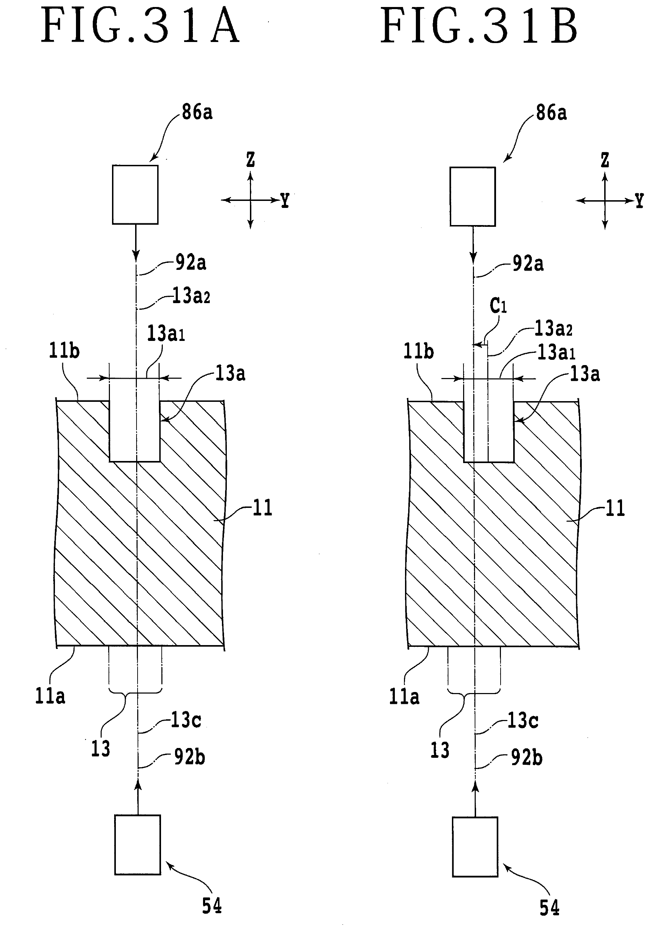

After the imaging step S50, the controller 94 detects misalignment between the first processing groove 13a and the projected dicing line 13, in reference to the image 88a captured by the upper side imaging unit 86a and the image 88b captured by the lower side imaging unit 54 (detecting step S60). FIGS. 31A and 31B are enlarged cross sectional views illustrating the detecting step S60

Note that, in FIGS. 31A and 31B, the upper side imaging unit 86a and the lower side imaging unit 54 are located at the same position in the X-Y plane with the workpiece 11 and the chuck table 10 sandwiched therebetween. However, this illustration is merely made for the sake of convenience and signifies that the lower side imaging unit 54 is set in such a manner as to image an area on the face side 11a that corresponds, in the X-Y plane, to an area on the reverse side 11b that is to be imaged by the upper side imaging unit 86a.

In the detecting step S60, as in the first embodiment, the controller 94 performs image processing to detect whether or not the position of the first center line 13a₂ of the first processing groove 13a and the position of the center line 13c of the projected dicing line 13 are aligned in the X-Y plane (predetermined plane). Note that the center line 13c of the projected dicing line 13 is a virtual straight line that is positioned at the center of the projected dicing line 13 in the width direction and that is substantially parallel to the longitudinal direction of the projected dicing line 13.

FIG. 31A is an enlarged cross sectional view illustrating part of the workpiece 11 in a case where the position of the first center line 13a₂ of the first processing groove 13a and the position of the center line 13c of the projected dicing line 13 are aligned in the X-Y plane in the fifth embodiment. In a case where the positions of the two center lines are aligned (YES in S62), the flow proceeds to an additional first processing groove forming step S72.

FIG. 31B is an enlarged cross sectional view illustrating part of the workpiece 11 in a case where the position of the first center line 13a₂ of the first processing groove 13a and the position of the center line 13c of the projected dicing line 13 are misaligned in the X-Y plane in the fifth embodiment. In FIG. 31B, the amount and direction of misalignment between the first center line 13a₂ and the reference line 92a in the Y-axis direction are represented by a vector C₁. In the detecting step S60, in a case where the position of the first center line 13a₂ and the position of the center line 13c are not aligned in the X-Y plane, the flow proceeds to the correcting step S70 as in the first embodiment.

At the time of performing cutting after the correcting step S70, the controller 94 corrects the position of the center 84a₂ of the first cutting blade 84a (that is, the processing position of the first cutting unit 78a) in such a manner as to cancel the amount and direction of misalignment corresponding to the vector C₁. As a result, in the subsequent cutting (that is, in the additional first processing groove forming step S72), the position of the first center line 13a₂ and the position of the center line 13c can be aligned in the X-Y plane. Note that, in FIG. 31B, in order to simplify the description, the reference line 92b and the center line 13c are aligned, but the reference line 92b and the center line 13c may be misaligned. In any case, the amount and direction of misalignment of the position of the center line 13c with respect to the position of the first center line 13a₂ are detected in the detecting step S60, and the amount and direction of misalignment are corrected in the correcting step S70.

In the additional first processing groove forming step S72, the first cutting unit 78a is sequentially indexing fed in the Y-axis direction from the position of the first processing groove 13a that is formed in the first processing groove forming step S22, and the first processing grooves 13a are additionally formed along all of the remaining projected dicing lines 13 extending along the first direction. Though not described in FIG. 28, after the first processing grooves 13a are formed along all of the projected dicing lines 13 extending along the first direction, the chuck table 10 is rotated by substantially 90 degrees. Then, the first processing grooves 13a are similarly formed along the projected dicing lines 13 extending along the second direction orthogonal to the first direction, through steps S22 to S72.

Also in the fifth embodiment, directly observing the face side 11a and the reverse side 11b allows the misalignment between the first center line 13a₂ and the center line 13c to be detected. In a case where the position of the first center line 13a₂ and the position of the center line 13c are misaligned, the workpiece 11 can be cut after correction is made to align the position of the first center line 13a₂ and the position of the center line 13c in the cutting to be performed along the next projected dicing line 13. In addition, according to this processing method, by the face side 11a and the reverse side 11b of the workpiece 11 being directly observed, even if there is any distortion in the shape of the alignment marks, impact that could be caused by the distortion in the shape of the alignment marks can be reduced. Note that, also in the fifth embodiment, as in the second embodiment, the first processing grooves 13a may be formed to have a V-shape as viewed in cross section, and as in the third embodiment, the first processing grooves 13a may be formed by laser ablation processing.

### (Sixth embodiment)

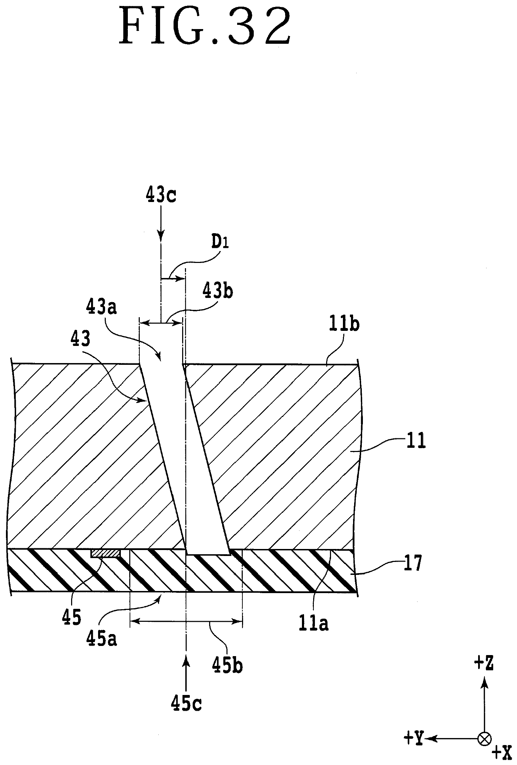

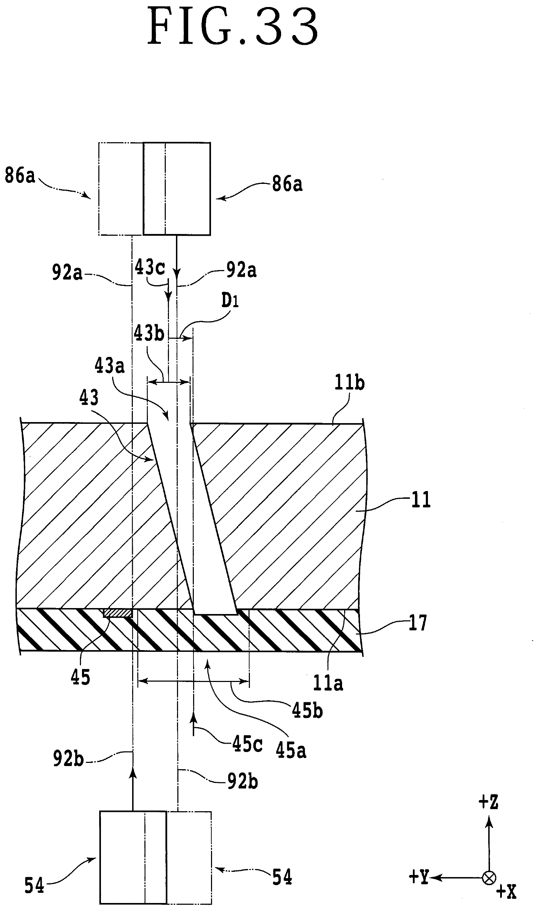

Next a sixth embodiment will be described with reference to FIGS. 32 and 33. In the sixth embodiment, the workpiece 11 is processed by the abovementioned cutting apparatus 2 in line with the flow illustrated in FIG. 28. Hence, description overlapping with those in the fifth embodiment will be omitted. In the sixth embodiment, in the first processing groove forming step S22 following the holding step S10, a first processing groove 43 that has a depth reaching the face side 11a from the reverse side 11b in the workpiece 11 is formed. Forming such a groove is the difference from the fifth embodiment.

In the first processing groove forming step S22, first, only one first processing groove 43 which is what is generally called a full-cut groove is formed (see FIG. 32). FIG. 32 is a view illustrating the first processing groove forming step S22 according to the sixth embodiment. As illustrated in FIG. 32, the first processing groove 43 is sometimes tilted with respect to the thickness direction (for example, the Z-axis direction) of the workpiece 11 (that is, what is generally called oblique cutting occurs). For example, what is generally called the oblique cutting occurs due to the first cutting blade 84a being attached to the spindle 82a in such a manner as to be tilted with respect to the spindle 82a, the first cutting blade 84a being unevenly worn, the cutting resistance of the workpiece 11 being relatively large, or other reasons.

Even when such oblique cutting occurs, there are cases where a center line (first center line) 45c of a width 45b of a projected dicing line 45a on the face side 11a and a center line (second center line) 43c of a width 43b of an opening 43a of the first processing groove 43 exposed on the reverse side 11b need to be aligned. Note that the center line 43c is positioned at the center of the opening 43a in the width direction and is substantially parallel to the longitudinal direction of the opening 43a orthogonal to the width direction. Similarly, the center line 45c is positioned at the center of the projected dicing line 45a in the width direction and is substantially parallel to the longitudinal direction of the projected dicing line 45a orthogonal to the width direction.

In the present embodiment, as illustrated in FIG. 33, after the first processing groove forming step S22, while the face side 11a is held under suction on the chuck table 10, the first processing groove 43 exposed on the reverse side 11b is imaged by the upper side imaging unit 86a, and a portion in the vicinity of the projected dicing line 45a is imaged by the lower side imaging unit 54 (imaging step S50). FIG. 33 is a view illustrating the imaging step S50 according to the sixth embodiment.

Each field of view to be used in the imaging by the lower side imaging unit 54 is in some cases smaller than the width 45b of the projected dicing line 45a including the first processing groove 43 exposed on the face side 11a. In this case, even if the projected dicing line 45a is imaged by the lower side imaging unit 54, the center line 45c of the width 45b of the projected dicing line 45a cannot be identified. As such, in the imaging step S50 according to the present embodiment, an alignment mark 45 formed in the vicinity of the projected dicing line 45a on the face side 11a is imaged by the lower side imaging unit 54.

After the imaging step S50, the controller 94 performs image processing to identify the position coordinates of the center line 45c of the projected dicing line 45a in reference to the position coordinates of the alignment mark 45. Note that the distance from the alignment mark 45 to the center line 45c is registered in advance in the cutting apparatus 2. Further, the controller 94 similarly identifies the coordinates of the center line 43c of the width 43b of the first processing groove 43 on the reverse side 11b by image processing. Thereafter, the controller 94 detects whether or not the position of the center line 43c and the position of the center line 45c are aligned in the X-Y plane (predetermined plane) (detecting step S60).

In FIGS. 32 and 33, the amount and direction of misalignment between the center line 43c and the center line 45c in the Y-axis direction are represented by a vector D₁. In a case where the position of the center line 43c and the position of the center line 45c are aligned in the X-Y plane (YES in S62), the flow proceeds to the additional first processing groove forming step S72. In contrast, in a case where the position of the center line 43c and the position of the center line 45c are not aligned in the X-Y plane, the flow proceeds to the correcting step S70.

At the time of performing cutting after the correcting step S70, the controller 94 corrects the position of the first cutting blade 84a (that is, the processing position of the first cutting unit 78a) in such a manner as to cancel the amount and direction of misalignment between the center line 43c and the center line 45c. As a result, in the subsequent cutting, the center line 43c of the opening 43a on the reverse side 11b can be adjusted to a position where the center line 45c of the projected dicing line 45a on the face side 11a is projected on the reverse side 11b.

### (Seventh embodiment)

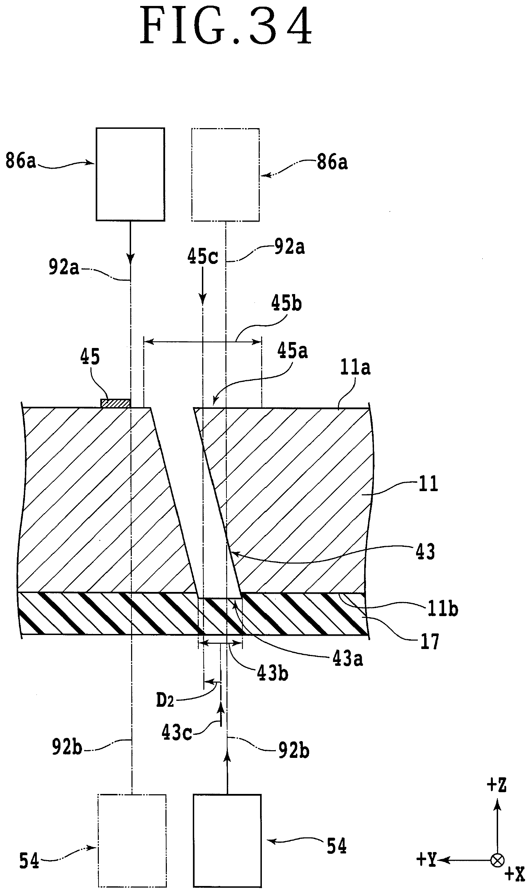

Next a seventh embodiment will be described with reference to FIG. 34. In the seventh embodiment, the tape 17 is affixed not to the face side 11a but to the reverse side 11b, and in the holding step S10 and the first processing groove forming step S22, the reverse side 11b is held under suction while the face side 11a is exposed. These points are the differences from the sixth embodiment. Hence, description overlapping with those in the sixth embodiment will be omitted.

In the first processing groove forming step S22 according to the seventh embodiment, a first processing groove 43 having a depth reaching the reverse side 11b from the face side 11a of the workpiece 11 is formed. Further, in the imaging step S50, in a state in which the reverse side 11b is held under suction, the first processing groove 43 reaching the reverse side 11b is imaged by the lower side imaging unit 54, while the alignment mark 45 formed in the vicinity of the projected dicing line 45a is imaged by the upper side imaging unit 86a (imaging step S50).

The controller 94 identifies the coordinates of the center line 45c of the projected dicing line 45a on the face side 11a and the coordinates of the center line 43c of the first processing groove 43 on the reverse side 11b and detects whether or not the position of the center line 43c and the position of the center line 45c are aligned in the X-Y plane (predetermined plane) (detecting step S60). FIG. 34 is a view illustrating the imaging step S50 according to the seventh embodiment. In FIG. 34, the amount and direction of misalignment between the center line 43c and the center line 45c in the Y-axis direction are represented by a vector D₂. In a case where the position of the center line 43c and the position of the center line 45c are aligned in the X-Y plane (YES in S62), the flow proceeds to the additional first processing groove forming step S72.

In contrast, in a case where the position of the center line 43c and the position of the center line 45c are not aligned in the X-Y plane, the flow proceeds to the correcting step S70. At the time of performing cutting after the correcting step S70, the controller 94 corrects the position of the first cutting blade 84a (that is, the processing position of the first cutting unit 78a) in such a manner as to cancel the amount and direction of misalignment between the center line 43c and the center line 45c. As a result, in the subsequent cutting, the center line 43c of the opening 43a on the reverse side 11b can be adjusted to a position where the center line 45c of the projected dicing line 45a on the face side 11a is projected on the reverse side 11b.

In addition, structures, methods, and other matters related to the abovementioned embodiments and modifications can be implemented with changes made as appropriate unless any divergence from the scope of object of the present invention occurs. The abovementioned embodiments and modifications can be combined as appropriate.

The present invention is not limited to the details of the above described preferred embodiments. The scope of the invention is defined by the appended claims and all changes and modifications as fall within the equivalence of the scope of the claims are therefore to be embraced by the invention.

## Claims

1. A processing method for a workpiece, comprising:
a first processing groove forming step of forming, by a first processing unit, a first processing groove that has a depth not reaching a face side of the workpiece, in a state in which the face side is held and a reverse side of the workpiece that is positioned on an opposite side of the face side is exposed;
an imaging step of, after the first processing groove forming step, imaging the first processing groove by a first imaging unit, in a state in which the workpiece is held by a holding table having an area formed with a transparent material, and imaging, by a second imaging unit provided on an opposite side of the first imaging unit with respect to the holding table, a predetermined line that is provided on the face side and that is formed at a position corresponding to that of the first processing groove in a thickness direction of the workpiece;
a detecting step of, after the imaging step, detecting whether or not a position of a first center line of the first processing groove imaged by the first imaging unit and a position of a second center line of the predetermined line imaged by the second imaging unit are aligned in a predetermined plane; and
a correcting step of, when the position of the first center line and the position of the second center line are detected as not being aligned in the detecting step, correcting a processing position in such a manner as to make the positions of the two center lines aligned.

2. The processing method for a workpiece according to claim 1, further comprising:
before the imaging step, a second processing groove forming step of forming, by a second processing unit, a second processing groove that is positioned on an opposite side of the first processing groove in the thickness direction of the workpiece and that has a depth not reaching the first processing groove, in a state in which the reverse side is held on the holding table and the face side is exposed, wherein
the predetermined line is an opening of the second processing groove formed in the face side,
in the detecting step, whether or not the position of the first center line of the first processing groove imaged by the first imaging unit and the position of the second center line of the second processing groove imaged by the second imaging unit are aligned in the predetermined plane is detected, and,
in the correcting step, a processing position of the second processing unit is corrected.

3. The processing method for a workpiece according to claim 2, wherein
at least one of the first processing unit or the second processing unit has a cutting blade that has a V-shaped outer circumferential end portion as viewed in cross section, and
at least one of the first processing groove or the second processing groove has a V-shape as viewed in cross section, according to the shape of the outer circumferential end portion of the cutting blade.

4. The processing method for a workpiece according to claim 2, wherein at least one of the first processing unit or the second processing unit is a laser application unit that is capable of emitting a pulsed laser beam having a wavelength absorbable by the workpiece.

5. The processing method for a workpiece according to any one of claims 2 to 4, further comprising:
a dividing step of dividing the workpiece by a third processing unit in such a manner as to connect to each other the first processing groove and the second processing groove that are formed in corresponding positions in the thickness direction of the workpiece.

6. The processing method for a workpiece according to any one of the preceding claims, wherein
the predetermined line is a projected dicing line set on the face side,
in the imaging step, the projected dicing line is imaged by the second imaging unit, and,
in the correcting step, a processing position of the first processing unit is corrected.

7. A processing method for a workpiece, comprising:
a first processing groove forming step of forming, by a first processing unit, a first processing groove that has a depth reaching a face side of the workpiece, in a state in which the face side is held and a reverse side of the workpiece that is positioned on an opposite side of the face side is exposed;
an imaging step of, after the first processing groove forming step, imaging the first processing groove exposed on the reverse side, by an upper side imaging unit that is located above a holding table having an area formed with a transparent material, in a state in which the face side of the workpiece is held under suction on the holding table, and imaging an alignment mark formed on the face side, by a lower side imaging unit that is located below the holding table;
a detecting step of, after the imaging step, detecting whether or not a position of a first center line of the first processing groove imaged by the upper side imaging unit and a position of a second center line of a projected dicing line identified in reference to the alignment mark imaged by the lower side imaging unit are aligned in a predetermined plane; and
a correcting step of, when the position of the first center line and the position of the second center line are detected as not being aligned in the detecting step, correcting a processing position in such a manner as to align the positions of the two center lines.

8. A processing method for a workpiece, comprising:
a first processing groove forming step of forming, by a first processing unit, a first processing groove that has a depth reaching a reverse side of the workpiece, in a state in which the reverse side of the workpiece is held and a face side of the workpiece that is positioned on an opposite side of the reverse side is exposed;
an imaging step of, after the first processing groove forming step, imaging the first processing groove exposed on the reverse side, by a lower side imaging unit that is located below a holding table having an area formed with a transparent material, in a state in which the reverse side of the workpiece is held under suction on the holding table, and imaging an alignment mark formed on the face side, by an upper side imaging unit that is located above the holding table;
a detecting step of, after the imaging step, detecting whether or not a position of a first center line of the first processing groove imaged by the lower side imaging unit and a position of a second center line of a projected dicing line identified in reference to the alignment mark imaged by the upper side imaging unit are aligned in a predetermined plane; and
a correcting step of, when the position of the first center line and the position of the second center line are detected as not being aligned in the detecting step, correcting a processing position in such a manner as to align the positions of the two center lines.
